(19) Europäisches Patentamt
European Patent Office
Office européen des brevets

(11) Veröffentlichungsnummer : **0 062 610**
**B1**

(12) **EUROPÄISCHE PATENTSCHRIFT**

(45) Veröffentlichungstag der Patentschrift : **24.04.85**

(51) Int. Cl.[4] : **G 03 C 1/68**, G 03 F 7/10

(21) Anmeldenummer : **82810139.4**

(22) Anmeldetag : **29.03.82**

(54) **Photopolymerisationsverfahren.**

(30) Priorität : **02.04.81 GB 8110402**

(43) Veröffentlichungstag der Anmeldung : **13.10.82 Patentblatt 82/41**

(45) Bekanntmachung des Hinweises auf die Patenterteilung : **24.04.85 Patentblatt 85/17**

(84) Benannte Vertragsstaaten : **BE CH DE FR GB IT LI NL SE**

(56) Entgegenhaltungen :
**EP-A- 0 021 019**
**GB-A- 1 544 299**
**GB-A- 1 544 840**

(73) Patentinhaber : **CIBA-GEIGY AG**
**Postfach**
**CH-4002 Basel (CH)**

(72) Erfinder : **Green, George Edward, Dr.**
**14 Vine Close**
**Stapleford Cambridge CB2 5BZ (GB)**
Erfinder : **Losert, Ewald**
**Habsburgerstrasse 30**
**CH-4310 Rheinfelden (CH)**
Erfinder : **Paul, John Gordon, Dr.**
**13, Alma Terrace Falkirk**
**Stirlingshire Schottland (GB)**
Erfinder : **Zweifel, Hans, Dr.**
**Lothringerstrasse 93**
**CH-4056 Basel (CH)**

**EP 0 062 610 B1**

Anmerkung : Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Jouve, 18, rue St-Denis, 75001 Paris, France

**Beschreibung**

Vorliegende Erfindung betrifft ein Photopolymerisations- und Photovernetzungsverfahren sowie insbesondere ein solches Verfahren zur Erzeugung von Abbildungen.

Ueblicherweise erfolgt die Erzeugung einer Abbildung mittels Photopolymerisation, indem man einen Träger mit einer Lösung einer photopolymerisierbaren Substanz in einem flüchtigen organischen Lösungsmittel beschichtet, das Lösungsmittel abdampft oder verdampfen lässt, so dass ein Film der photopolymerisierbaren Substanz verbleibt, den Film mit aktinischer Strahlung wie durch eine Abbildung hindurch bestrahlt, wodurch die von der Strahlung getroffenen Stellen des Films photopolymerisiert (und weniger löslich) werden, während die von der Strahlung abgeschirmten Stellen weitgehend unverändert bleiben, und dann die unbestrahlten, unphotopolymerisierten Stellen des Films mittels eines geeigneten Lösungsmittels, welches die bestrahlten, photopolymerisierten Stellen nicht auflöst, weglöst. Diese letzte Stufe ist üblicherweise als « Entwicklung » bekannt.

Es wäre wünschenswert, ein Verfahren zur Verfügung zu haben, bei dem eine Schicht einer photopolymerisierbaren Substanz auf einen Träger aufgebracht und diese Schicht ohne Anwendung organischer Lösungsmittel in einen weitgehend festen, klebfreien, bestrahlungsfertigen Zustand überführt würde. In dieser Stufe würde man nicht nur die Anwendung von Lösungsmitteln, die zu Toxizitäts- und Brennbarkeitsproblemen führen könnten und auch Rückgewinnungskosten verursachen, vermeiden, sondern auch die Herstellung beschichteter, bestrahlungsfertiger Träger auf kontinuierliche Weise würde erleichtert werden.

Es wurde nun gefunden, dass man diese Aufgabe dadurch lösen kann, dass man gewisse Substanzen, die im Molekül zwei Arten von Gruppen enthalten, über welche Photopolymerisation mit beträchtlich voneinander verschiedenen Geschwindigkeiten eintreten kann, verwendet. Die Gruppen werden so ausgewählt, dass Photopolymerisation einer Schicht einer flüssigen Zusammensetzung zu einer festen, im wesentlichen klebfreien Schicht, die jedoch in bestimmten Lösungsmitteln noch löslich ist, rasch eintritt. Anschließend setzt man Stellen der Schicht einer wesentlich grösseren Menge aktinischer Strahlung aus, wobei Photovernetzung über den anderen Typus von Gruppe in den bereits photopolymerisierten Molekülen der Schicht eintritt und die der Photovernetzung unterworfenen Stellen der Schicht viel beständiger gegen Auflösung in den Lösungsmitteln werden.

Unveröffentlichte Versuche der Anmelderin haben gezeigt, dass zahlreiche möglicherweise nützliche Verbindungen, die zwei Typen normalerweise photopolymerisationsfähiger Einheiten enthalten, bei einem solchen Verfahren keine befriedigenden Ergebnisse liefern, da die Photopolymerisation in der ersten Stufe erheblich verzögert wird, anscheinend als Folge der Gegenwart eines anderen Typs photopolymerisierbarer Einheit, trotz des Einbaus verschiedener Photoinitiatoren und Photosensibilisatoren. Weitere unveröffentlichte Versuche der Anmelderin mit Gemischen aus zwei Verbindungen, wovon eine eine normalerweise photopolymerisationsfähige Einheit und die andere eine unterschiedliche, normalerweise photovernetzbare Einheit enthalten, lieferten unbefriedigende Ergebnisse, offensichtlich wegen Hemmung der Photovernetzungsreaktion.

Es wurde nun gefunden, dass man das gewünschte Verfahren realisieren kann, wenn man eine Verbindung einsetzt, die im selben Molekül sowohl eine oder mehrere Acryloyl- oder Methacryloylgruppen als auch eine oder mehrere 2,3-disubstituierte Maleinimidgruppen enthält.

Ein Gegenstand dieser Erfindung ist dementsprechend ein Verfahren zur Erzeugung einer Abbildung, welches dadurch gekennzeichnet ist, dass man (1) eine auf einem Träger aufgebrachte Schicht aus einer flüssigen Zusammensetzung, die eine Verbindung (A) mit sowohl mindestens einer Gruppe der Formel

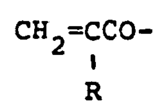
(I)

als auch mindestens einer Gruppe der Formel

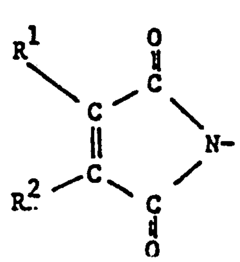
(II)

im selben Molekül enthält, wobei R ein Wasserstoffatom oder eine Methylgruppe bedeutet sowie $R^1$ und $R^2$ gleich oder verschieden sind und je eine Alkylgruppe mit 1 bis 4 Kohlenstoffatomen oder zusammen

eine gegebenenfalls durch eine Methylgruppe substituierte Trimethylen- oder Tetramethylengruppe darstellen, so mit aktinischer Strahlung belichtet, dass sich die Schicht durch Photopolymerisation von (A) über die Gruppe bzw. Gruppen der Formel I verfestigt und im wesentlichen klebfrei wird, jedoch weitgehend photovernetzbar bleibt, und anschliessend (2) die so verfestigte Schicht durch eine bildtragende Vorlage mit weitgehend undurchsichtigen und weitgehend durchsichtigen Stellen hindurch mit einer wesentlich grösseren Menge aktinischer Strahlung belichtet, so dass die weiterbelichtete(n) Stelle(n) der photopolymerisierten Schicht über die Gruppe bzw. Gruppen der Formel II Photovernetzung eingehen, und (3) die Abbildung durch Auflösung der nichtphotovernetzten Stelle(n) der Schicht in einem Lösungsmittel entwickelt.

In der britischen Patentschrift Nr. 1 544 840 ist die Herstellung zahlreicher 2,3-disubstituierter Maleinimideinheiten, insbesondere 2,3-Dimethylmaleinimidoeinheiten enthaltender Verbindungen beschrieben, einschliesslich einiger, die ferner Acryloyl- oder Methacryloylgruppen enthalten. Aus der britischen Patentschrift Nr. 1 544 299 sind durch aktinische Strahlung vernetzbare, 2,3-disubstituierte Maleinimideinheiten enthaltende Polymere bekannt. Dort wird angegeben, dass Monomere, die neben der im 2,3-disubstituierten Maleinimidorest der Formel II vorhandene Doppelbindung eine weitere äthylenisch ungesättigte Doppelbindung enthalten, die leichter als der 2,3-disubstituierte Maleinimidorest der Formel II polymerisierbar ist, sich mittels Radikalinitiatoren so polymerisieren lassen, dass man Polymere erhält, die keine vernetzte Struktur aufweisen und die 2,3-disubstituierten Maleinimidogruppen der Formel II als Seitensubstituenten tragen und nachträglich durch elektromagnetische Bestrahlung vernetzbar sind. So wurde in Beispielen N-(3-(Acryloyloxy)-propyl)-2,3-dimethylmaleinimid zusammen mit Methylmethacrylat, Glycidylmethacrylat, Aethylacrylat oder 2-Hydroxyäthylacrylat mittels Benzoylperoxyd oder 2,2'-Azobis-(2-methylpropionitril) polymerisiert. Dass die Vinylpolymerisationen sämtlich unter Verwendung von chemischen Radikalinitiatoren erfolgten, deutet darauf hin, dass die Vinylpolymerisationen zu 2,3-disubstituierte, noch photopolymerisierbare Maleinimidogruppen enthaltenden Polymeren mit aktinischer Strahlung nicht durchführbar waren. Es besteht kein Hinweis darauf, dass eine Verbindung mit Gruppen der Formel I und der Formel II zunächst durch Belichtung mit aktinischer Strahlung zu einem polymeren Material polymerisiert werden könnte, dessen Löslichkeit sich von der des durch weitere Belichtung des polymeren Materials mit aktinischer Strahlung erhaltenen Produkts genügend unterscheidet, damit es als Photoresist in einem abbildungserzeugenden Verfahren verwendbar ist.

Ueblicherweise wird die im erfindungsgemässen Verfahren eingesetzte Verbindung (A) pro Durchschnittsmolekül bis vier Gruppen der Formel I und bis vier Gruppen der Formel II enthalten. Vorzugsweise besitzt sie ein Molekulargewicht von höchstens 2 000. Bevorzugt sind die Gruppe(n) der Formel I sowie auch die Gruppe(n) der Formel II jeweils direkt an ein Kohlenstoff-, Sauerstoff- oder Stickstoffatom bzw. -atome gebunden ; in besonders bevorzugten Verbindungen bedeuten $R^1$ und $R^2$ in Formel II je eine Methylgruppe.

Als (A) geeignete Verbindungen lassen sich dadurch erhalten, dass man gleichzeitig oder in beliebiger Reihenfolge eine Verbindung mit zwei oder mehr direkt an ein Sauerstoff-, Stickstoff- oder Schwefelatom bzw. -atome gebundenen Glycidylgruppen mit Acryl- oder Methacrylsäure und mit einer 2,3-disubstituierten Maleinimido-carbonsäure der Formel

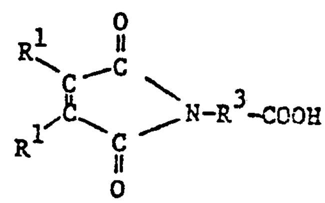

(III)

worin $R^1$ und $R^2$ die unter Formel II angegebenen Bedeutungen haben und $R^3$ nach Wegnahme einer primären Aminogruppe und einer Carboxylgruppe den zweiwertigen Rest einer Verbindung mit mindestens einer solchen Aminogruppe und mindestens einer Carboxylgruppe, vorzugsweise einen aliphatischen, cycloaliphatischen, aromatischen, araliphatischen oder heterocyclischen Rest mit 1 bis 12 Kohlenstoffatomen darstellt, umsetzt.

Als Verbindung (A) verwendbare Substanzen sind somit solche der allgemeinen Formel

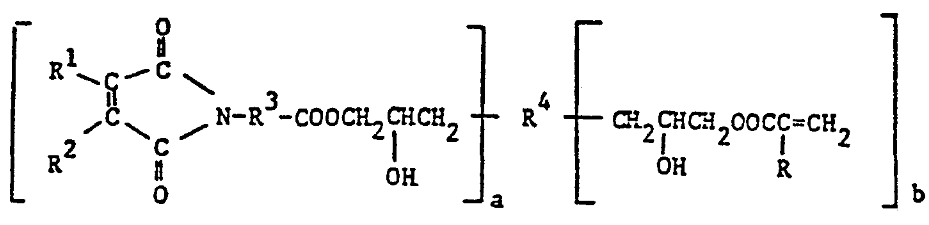

(IV)

worin a und b unabhängig voneinander je eine ganze Zahl von mindestens 1 und vorzugsweise höchstens 4 sind, R die unter Formel I, $R^1$ und $R^2$ die unter Formel II und $R^3$ die unter Formel III angegebenen

Bedeutungen haben und $R^4$ nach Wegnahme von (a + b) direkt an ein Sauerstoff-, Stickstoff- oder Schwefelatom bzw. -atome gebundenen Glycidylgruppen den Rest einer mindestens (a + b) solche Glycidylgruppen enthaltenden Verbindung darstellt.

Es ist ersichtlich, dass das Produkt ebenfalls Addukte aus der Verbindung mit zwei oder mehr Glycidylgruppen und Acryl- oder Methacrylsäure allein oder aus der Verbindung mit zwei oder mehr Glycidylgruppen und der 2,3-disubstituierten Maleinimidocarbonsäure allein enthalten wird, d. h. Verbindungen der Formel

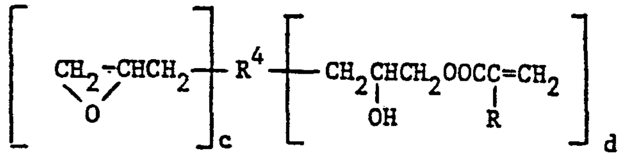

(V)

und Verbindungen der Formel

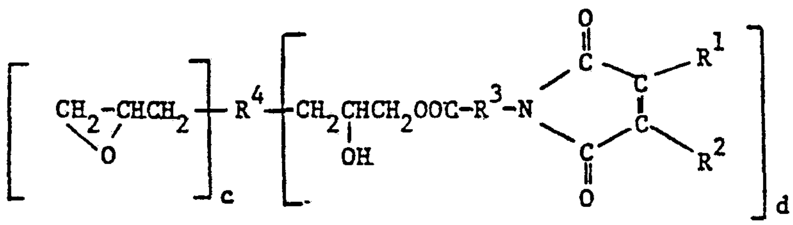

(VI)

worin c null oder eine positive ganze Zahl und d eine ganze Zahl von mindestens eins sind, wobei die Summe (c + d) gleich der Summe (a + b) ist, und R die unter Formel I, $R^1$ und $R^2$ die unter Formel II, $R^3$ die unter Formel III und $R^4$ die unter Formel IV angegebenen Bedeutungen haben.

Das Ausmass der Bildung der Nebenprodukte der Formel V oder VI hängt natürlich von den Anteilen der drei Typen eingesetzter Reaktionspartner ab. Im allgemeinen wird die Durchführung des erfindungsgemässen Verfahrens durch die Gegenwart solcher Nebenprodukte nicht gestört.

Carbonsäuren der Formel III sind durch Umsetzung eines 2,3-disubstituierten Maleinsäureanhydrids mit einer Aminosäure der Formel $H_2NR^3COOH$ wie in der oben erwähnten britischen Patentschrift Nr. 1 544 840 beschrieben erhältlich. Dabei kann $R^3$ beispielsweise für eine p-Phenylen-, Methylen-, Aethylen-, Pentamethylen- oder Aethylidengruppe stehen.

Als Verbindung (A) geeignete Substanzen kann man auf ähnliche Weise, unter Ersatz der Carbonsäure der Formel III durch ein 2,3-disubstituiertes Maleinimidophenol der Formel VII

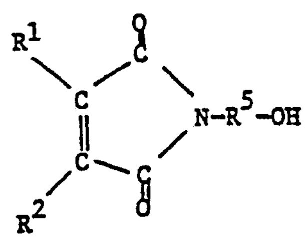

(VII)

worin $R^1$ und $R^2$ die unter Formel II angegebenen Bedeutungen haben und $R^5$ nach Wegnahme einer primären Aminogruppe und einer phenolischen Hydroxylgruppe für den zweiwertigen Rest einer mindestens eine solche Aminogruppe und mindestens eine solche Hydroxylgruppe enthaltenden Verbindung, vorzugsweise einen aromatischen Rest mit 6 bis 18 Kohlenstoffatomen steht, zusammen mit Acrylsäure oder Methacrylsäure erhalten.

Dementsprechend sind Verbindungen der Formel

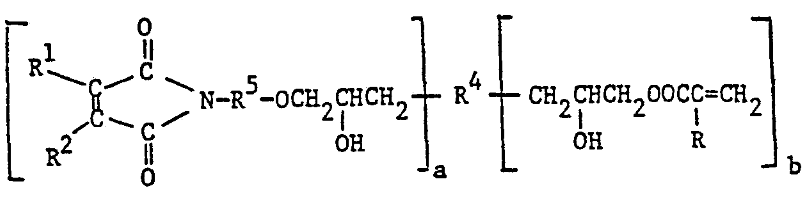

(VIII)

worin R die unter Formel I, $R^1$ und $R^2$ die unter Formel II, $R^4$ die unter Formel IV, $R^5$ die unter Formel VII sowie a und b die unter Formel IV angegebenen Bedeutungen haben, verwendbar.

Phenole der Formel VII sind durch Umsetzung eines 2,3-disubstituierten Maleinsäureanhydrids mit einem Aminophenol der Formel $H_2NR^5OH$ wie in der oben erwähnten britischen Patentschrift Nr. 1 544 840 beschrieben erhältlich. $R^5$ kann dabei beispielsweise für eine o-, m- oder p-Phenylengruppe stehen.

Das Produkt wird ebenfalls Addukte aus der Verbindung mit zwei oder mehr Glycidylgruppen und Acryl- oder Methacrylsäure allein oder aus der Verbindung mit zwei oder mehr Glycidylgruppen und dem 2,3-disubstituierten Maleinimidophenol allein enthalten, d. h. Verbindungen der Formel V und Verbindungen der Formel

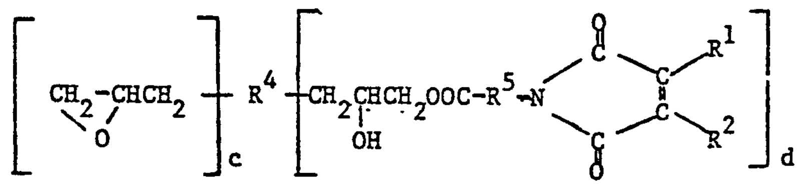 (IX)

worin $R^1$ und $R^2$ die unter Formel II, $R^3$ die unter Formel III, $R^4$ die unter Formel IV, $R^5$ die unter Formel VII sowie c und d die unter Formeln V und VI angegebenen Bedeutungen haben, wobei deren Anteile von dem Verhältnis der drei Typen eingesetzter Reaktionspartner abhängig sind. Die Durchführung des Verfahrens wird durch diese Nebenprodukte ebenfalls im allgemeinen nicht gestört.

Als Beispiele für Glycidylgruppen enthaltende Verbindungen, die mit Acryl- oder Methacrylsäure und mit einer 2,3-disubstituierten Maleinimidocarbonsäure der Formel III oder einem 2,3-disubstituierten Maleinimidophenol der Formel VII behandelt werden können, seien Polyglycidylester genannt, die man durch Umsetzung einer Verbindung mit zwei oder mehr Carbonsäuregruppen pro Molekül mit Epichlorhydrin oder Glycerindichlorhydrin in Gegenwart von Alkali erhalten kann. Solche Polyglycidylester können sich von aliphatischen Polycarbonsäuren, z. B. Bernsteinsäure, Glutarsäure, Adipinsäure, Pimelinsäure, Korksäure, Azelainsäure, Sebacinsäure oder dimerisierter oder trimerisierter Linolsäure, von cycloaliphatischen Polycarbonsäure wie Tetrahydrophthalsäure, 4-Methyltetrahydrophthalsäure, Hexahydrophthalsäure und 4-Methylhexahydrophthalsäure sowie von aromatischen Polycarbonsäuren wie Phthalsäure, Isophthalsäure und Terephthalsäure ableiten. Weitere geeignete Polyglycidylester sind durch Polymerisation von Glycidylestern von Vinylsäuren, insbesondere Glycidylacrylat und Glycidylmethacrylat, erhältlich.

Weitere Beispiele sind Polyglycidyläther, die durch Umsetzung einer mindestens zwei freie alkoholische und/oder phenolische Hydroxylgruppen pro Molekül enthaltenden Verbindung mit Epichlorhydrin unter alkalischen Bedingungen, oder auch in Gegenwart eines sauren Katalysators mit nachfolgender Alkalibehandlung, erhältlich sind. Diese Aether lassen sich mit Polyepichlorhydrinen aus acyclischen Alkoholen wie Aethylenglykol, Diäthylenglykol und höheren Poly-(oxyäthylen)-glykolen, Propan-1,2-diol und Poly-(oxypropylen)-glykolen, Propan-1,3-diol, Poly-(oxytetramethylen)-glykolen, Pentan-1,5-diol, Hexan-2,4,6-triol, Glycerin, 1,1,1-Trimethylolpropan, Pentaerythrit und Sorbit, aus cycloaliphatischen Alkoholen wie Resorcit, Chinit, Bis-(4-hydroxycyclohexyl)-methan, 2,2-Bis-(4-hydroxycyclohexyl)-propan und 1,1-Bis-(hydroxymethyl)-cyclohexen-3 und aus Alkoholen mit aromatischen Kernen, wie N,N-Bis-(2-hydroxyäthyl)-anilin und p,p'-Bis-(2-hydroxyäthylamino)-diphenylmethan herstellen. Man kann sie ferner aus einkernigen Phenolen wie Resorcin und Hydrochinon und mehrkernigen Phenolen wie Bis-(4-hydroxyphenyl)-methan (sonst als Bisphenol F bekannt), 4,4'-Dihydroxydiphenyl, Bis-(4-hydroxyphenyl)-sulfon, 1,1,2,2-Tetrakis-(4-hydroxyphenyl)-äthan, 2,2-Bis-(4-hydroxyphenyl)-propan (sonst als Bisphenol A bekannt) und 2,2-Bis-(3,5-dibrom-4-hydroxyphenyl)-propan sowie aus Aldehyden wie Formaldehyd, Acetaldehyd, Chloral und Furfurol mit Phenolen wie Phenol selbst und durch Chloratome oder Alkylgruppen mit jeweils bis zu 9 Kohlenstoffatomen ringsubstituiertem Phenol wie 4-Chlorphenol, 2-Methylphenol und 4-tert.-Butylphenol gebildeten Novolaken erhalten.

Poly-(N-glycidyl)-verbindungen sind ebenfalls verwendbar, z. B. N-Glycidylderivate von Aminen wie Anilin, n-Butylamin, Bis-(4-aminophenyl)-methan und Bis-(4-methylaminophenyl)-methan, Triglycidylisocyanurat sowie N,N'-Diglycidylderivate von cyclischen Alkylenharnstoffen, wie Aethylenharnstoff und 1,3-Propylenharnstoff, und Hydantoinen wie 5,5-Dimethylhydantoin.

Auch kann man Poly-(S-glycidyl)-verbindungen einsetzen, z. B. Di-(S-glycidyl)-derivate von Dithiolen wie Aethan-1,2-dithiol und Bis-(4-mercaptomethylphenyl)-äther, doch sind diese nicht bevorzugt.

In Betracht kommen auch Polyepoxide, in welchen die 1,2-Epoxidgruppen an Heteroatome verschiedener Art gebunden sind, beispielsweise der Glycidyläther/Glycidylester der Salicylsäure oder p-(Diglycidylamino)-phenylglycidyläther.

Besonders bevorzugt steht $R^4$ für den zweiwertigen Rest eines gegebenenfalls vorverlängerten Polyglycidyläthers aus einem mehrwertigen Phenol oder einem mehrwertigen aliphatischen Alkohol.

Als Komponente (A) verwendbare Verbindungen sind auch durch Umsetzung einer Verbindung mit zwei oder mehr alkoholischen Hydroxylgruppen mit Acryloyl- oder Methacryloylchlorid und einem 2,3-disubstituierten Maleinimidosäurechlorid der Formel

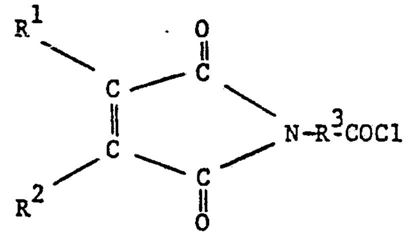

(X)

worin $R^1$ und $R^2$ die unter Formel II und $R^3$ die unter Formel III angegebenen Bedeutungen haben, erhältlich.

Dementsprechend kann man Verbindungen der Formel

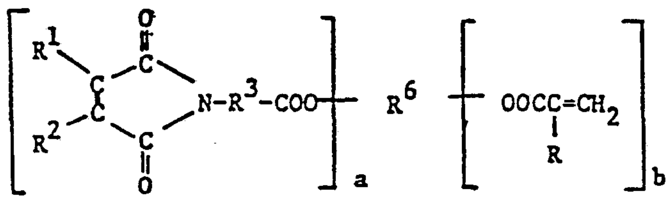

(XI)

worin a und b die unter Formel IV, R die unter Formel I, $R^1$ und $R^2$ die unter Formel II und $R^3$ die unter Formel III angegebenen Bedeutungen haben und $R^6$ nach Wegnahme von (a + b) alkoholischen Hydroxylgruppen den Rest eines Alkohols mit mindestens (a + b) solchen Hydroxylgruppen bedeutet, verwenden.

Vorzugsweise steht $R^6$ für einen wiederkehrende Einheiten der Formel

$$-(CH_2)_m- \qquad \text{(XII)}$$

worin m 2, 3 oder 4 ist, oder $-CO(CH_2)_5-$, $-CH_2\overset{|}{C}H-$ oder $-CH(CH_3)CH_2-$ enthaltenden aliphatischen Rest.

So kann $R^6$ beispielsweise für den Rest eines Poly-(oxyäthylen)-glykols oder Poly-(oxypropylen)-glykols vom Durchschnittsmolekulargewicht 250 bis 5 000 oder den Rest eines Polyvinylalkohols vom Durchschnittsmolekulargewicht 500 bis 9 000 stehen.

Wege zur Herstellung der Säurechloride der Formel X sind in der schon erwähnten britischen Patentschrift Nr. 1 544 840 beschrieben.

Es versteht sich, dass sich dabei in ähnlicher Weise Nebenprodukte der Formel

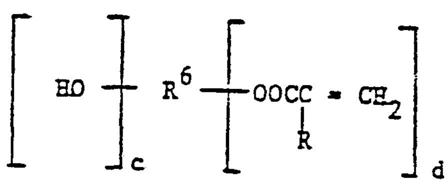

(XIII)

sowie der Formel

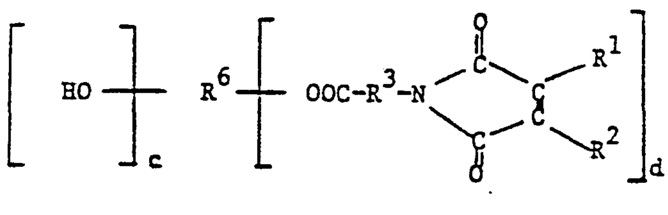

(XIV)

worin c und d die unter Formeln V und VI, $R^1$ und $R^2$ die unter Formel II, $R^3$ die unter Formel III und $R^6$ die unter Formel XI angegebenen Bedeutungen haben, bilden. Sie stören jedoch nicht das Verfahren.

Weitere als Komponente (A) geeignete Verbindungen entsprechen der allgemeinen Formel

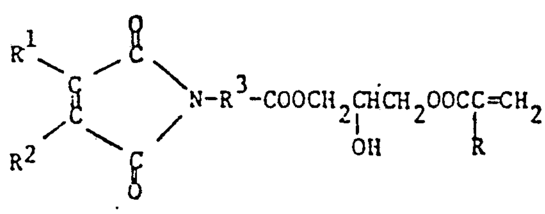

(XV)

oder der allgemeinen Formel

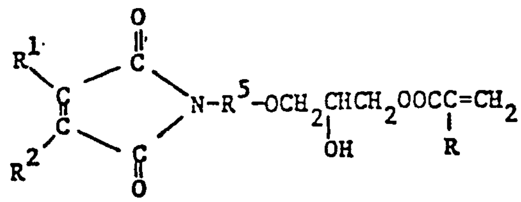

(XVI)

worin R die unter Formel I, $R^1$ und $R^2$ die unter Formel II, $R^3$ die unter Formel III und $R^5$ die unter Formel VII angegebenen Bedeutungen haben.

Verbindungen der Formel XV bzw. XVI kann man durch Umsetzung von Glycidylacrylat oder Glycidylmethacrylat mit einer 2,3-disubstituierten Maleinimido-carbonsäure der Formel III bzw. einem 2,3-disubstituierten Maleinimidophenol der Formel VII erhalten.

Noch weitere, als (A) verwendbare Verbindungen entsprechen der allgemeinen Formel

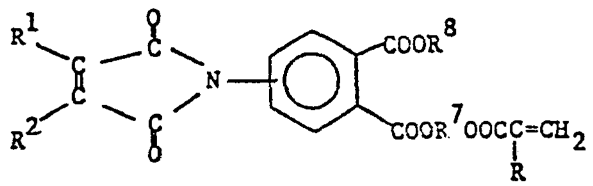

(XVII)

worin R die unter Formel I sowie $R^1$ und $R^2$ die unter Formel II angegebenen Bedeutungen haben, $R^7$ eine Alkylengruppe mit 2 oder 3 Kohlenstoffatomen bedeutet und $R^8$ ein Wasserstoffatom oder eine Gruppe der Formel

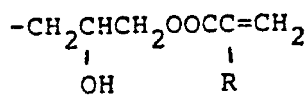

(XVIII)

oder

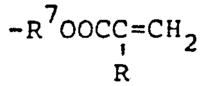

(XIX)

darstellt.

Solche Verbindungen, worin $R^8$ für ein Wasserstoffatom steht, lassen sich durch Umsetzung des Natriumsalzes einer Aminophthalsäure mit einem disubstituierten Maleinsäureanhydrid in Toluol/Wasser und nachfolgendes Ansäuern zur Isolierung der 2,3-disubstituierten Maleinimido-phthalsäure, Dehydratisierung zur Bildung des Anhydrids und dann Umsetzung mit einem Hydroxyalkylacrylat oder -methacrylat wie in der oben erwähnten britischen Patentschrift Nr. 1 544 299 beschrieben herstellen. So kann man 3-(2,3-Dimethylmaleinimido)-phthalsäureanhydrid mit 2-Hydroxyäthylmethacrylat in 2-(5-Methyl-3-oxa-4-oxohex-5-enyloxycarbonyl)-6-(2,3-dimethylmaleinimido)-benzoesäure überführen. Verbindungen der Formel XVII, worin $R^8$ für eine Gruppe der Formel XVIII steht, sind erhältlich durch Umsetzung von Glycidyl-(meth)acrylat mit der Säure der Formel XVII, worin $R^8$ für ein Wasserstoffatom steht, und Verbindungen der Formel XVII, worin $R^8$ für eine Gruppe der Formel XVIII oder XIX steht, sind erhältlich durch weitere Umsetzung jener Säure mit 2-Hydroxyäthyl- oder 2-Hydroxypropyl-(meth)acrylat.

Ferner kommen Verbindungen der allgemeinen Formel

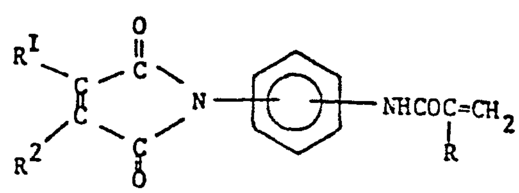

(XX)

worin R die unter Formel I sowie $R^1$ und $R^2$ die unter Formel II angegebenen Bedeutungen haben, in Betracht.

Die Umsetzung eines Phenylendiamins mit einem disubstituierten Maleinsäureanhydrid lässt sich so durchführen, dass sie das monosubstituierte Imid-amin wie in der oben erwähnten britischen Patentschrift Nr. 1 544 840 offenbart liefert, welches man dann mit (Meth)acryloylchlorid in der üblichen Weise unter Bildung eines Imidamids der Formel XX behandeln kann.

Ebenfalls infragekommende Amid-imide der allgemeinen Formel

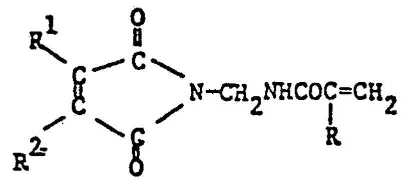

(XXI)

worin R die unter Formel I sowie $R^1$ und $R^2$ die unter Formel II angegebenen Bedeutungen haben, lassen sich durch Ueberführung eines 2,3-disubstituierten Maleinimids mit Formaldehyd in sein N-Hydroxymethylderivat und nachträgliche Umsetzung mit (Meth)acrylamid oder durch Umsetzung eines 2,3-disubstituierten Maleinimids mit N-Hydroxymethyl- oder N-Methoxymethyl-(meth)acrylamid erhalten.

Gleichfalls verwendbare Verbindungen der allgemeinen Formel

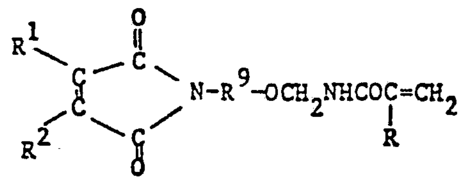

(XXII)

worin R die unter Formel I sowie $R^1$ und $R^2$ die unter Formel II angegebenen Bedeutungen haben und $R^9$ nach Wegnahme einer primären Aminogruppe und einer alkoholischen Hydroxylgruppe den zweiwertigen Rest einer mindestens eine solche Aminogruppe und mindestens eine solche Hydroxylgruppe enthaltenden Verbindung, vorzugsweise einen aliphatischen Rest mit 2 bis 6 Kohlenstoffatomen oder einen cycloaliphatischen Rest mit 6 bis 8 Kohlenstoffatomen darstellt, sind durch Umsetzung eines disubstituierten Maleinimidoalkohols der Formel

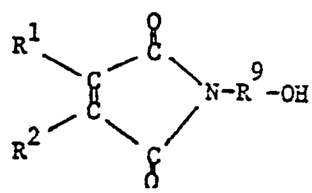

(XXIII)

mit N-(Hydroxymethyl)-acrylamid, N-(Hydroxymethyl)-methacrylamid oder den entsprechenden N-(Methoxymethyl)-verbindungen herstellbar.

Durch Umsetzung eines disubstituierten Maleinimidophenols der Formel VII mit (Meth)acryloylchlorid erhältliche Verbindungen der allgemeinen Formel

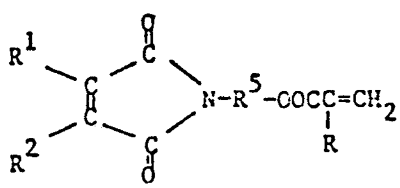

(XXIV)

worin R die unter Formel I, $R^1$ und $R^2$ die unter Formel II und $R^5$ die unter Formel VII angegebenen Bedeutungen haben, sind ebenfalls verwendbar.

Vorzugsweise entspricht (A) der allgemeinen Formel

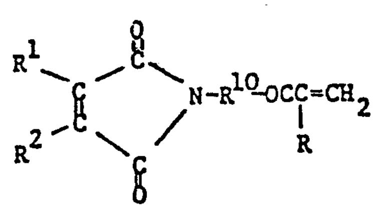

(XXV)

worin R die unter Formel I sowie $R^1$ und $R^2$ die unter Formel II angegebenen Bedeutungen haben und $R^{10}$ eine Iminogruppe, eine Alkylenoxygruppe mit 1 bis 10 Kohlenstoffatomen, eine 2-Hydroxypropylenoxygruppe, eine Poly-(oxyalkylen)-gruppe mit 4 bis 12 Kohlenstoffatomen, eine Cycloalkylenoxygruppe mit 5 bis 7 Kohlenstoffatomen oder eine Alkylencarbonamidgruppe mit 2 bis 10 Kohlenstoffatomen darstellt.

$R^{10}$ kann beispielsweise für eine Alkylencarbonamidogruppe der Formel $-(CH_2)_5CONH-$, eine Alkylenoxygruppe der Formel $-(CH_2)_6O-$, eine Cyclohexylenoxygruppe oder eine Methylcyclohexylenoxygruppe stehen; vorzugsweise bedeutet es eine Gruppe der Formel $-(CH_2)_{m-1}O-$, $-CH_2CH(CH_3)O-$, $-CH_2CH(OH)CH_2O-$ oder

$$-(\underset{\displaystyle R}{\underset{|}{C}}HCH_2O)_m- \qquad \text{(XXVI)}$$

worin m die unter Formel XII angegebene Bedeutung hat.

Verbindungen der Formel XXV, worin $R^{10}$ für eine Iminogruppe steht, lassen sich aus N-amino-2,3-disubstituiertem Maleinimid durch Behandlung mit Acryloyl- oder Methacryloylchlorid erhalten.

Verbindungen der Formel XXV, worin $R^{10}$ für eine Alkylenoxygruppe mit mindestens 2 Kohlenstoffatomen oder eine Poly-(oxyalkylen)-gruppe steht, sind durch Umsetzung eines 2,3-disubstituierten Maleinsäureanhydrids mit einem Aminoalkohol und nachfolgende Behandlung mit Acryloyl- oder Methacryloylchlorid herstellbar, während solche, worin $R^{10}$ für $-CH_2O-$ steht, durch Ueberführung eines 2,3-disubstituierten Maleinimids in sein N-Hydroxymethylderivat mittels Formaldehyd und nachfolgende Behandlung mit (Meth)-acryloylchlorid erhalten werden können. Solche Verbindungen, worin $R^{10}$ für $-CH_2CH(OH)CH_2O-$ steht, kann man durch Umsetzung eines N-glycidyl-2,3-disubstituierten Maleinimids mit Acrylsäure oder Methacrylsäure erhalten. Verbindungen der Formel XXV, worin $R^{10}$ für eine Cycloalkenoxygruppe steht, sind durch Umsetzung eines 2,3-disubstituierten Maleinsäureanhydrids mit einem cycloaliphatischen Aminoalkohol und nachfolgende Behandlung mit Acryloyl- oder Methacryloylchlorid herstellbar.

Verbindungen der Formel XXV, worin $R^{10}$ für eine Alkylencarbonamidogruppe steht, kann man durch Umsetzung eines 2,3-disubstituierten Maleinsäureanhydrids mit einer aminosubstituierten aliphatischen Carbonsäure unter Bildung des N-(carboxyalkylen)-2,3-disubstituierten Maleinimids, Ueberführung in das Säurechlorid und Reaktion mit Acrylamid or Methacrylamid erhalten.

Herstellungsmethoden für solche Verbindungen (A) sind in der oben erwähnten britischen Patentschrift Nr. 1 544 840 beschrieben.

Spezielle Beispiele für zur Verwendung als Verbindung (A) geeignete Substanzen sind N-(2-(Acryloyloxy)-äthyl)-2,3-dimethylmaleinimid, N-(3-(Acryloyloxy)-2-hydroxypropyl)-2,3-dimethylmaleinimid, N-(3-(Acryloyloxy)-propyl)-2,3-dimethylmaleinimid, die entsprechenden Methacryloylhomologen, N-(2-(2-(Methacryloyloxy)-äthoxy)-äthyl)-2,3-dimethylmaleinimid und die 2-(Acryloyloxy)-äthyl-3-(methacryloyloxy)-2-hydroxypropylester der 3- und 4- (2,3-Dimethylmaleinimido)-phthalsäure.

Zur Photopolymerisation über Gruppen der Formel I ist es bei weitem vorzuziehen, dass die flüssige Zusammensetzung einen zugesetzten Photoinitiator enthält, d. h. einen Katalysator, der bei Bestrahlung einen angeregten Zustand ergibt, der zur Bildung freier Radikale führt, die dann die Polymerisation von (A) einleiten. Beispiele für geeignete Photoinitiatoren sind organische Peroxyde und Hydroperoxyde, α-halogensubstituierte Acetophenone wie Trichlormethyl-4'-tert.-butylphenylketon, α-hydroxy-α-alkyl-substituierte Acetophenone wie 2-Hydroxy-2-methyl-1-phenylpropanon-1, Benzoin und dessen Alkyläther (z. B. der n-Butyläther), α-Methylbenzoin, α-Dialkoxy-α-benzoylessigsäurealkylester, Benzophenone wie Benzophenon selbst und 4,4'-Bis-(dimethylamino)-benzophenon,O-Alkoxycarbonylderivate eines Oxims des Benzils oder 1-Phenylpropan-1,2-dions, wie Benzil-(O-äthoxycarbonyl)-α-monoxim und 1-Phenylpropan-1,2-dion-2-(O-äthoxycarbonyl)-oxim, Benzilketale, z. B. dessen Dimethylketal, substituierte Thioxanthone, z. B. 2-Chlorthioxanthon, Anthrachinone, Ester der Phenylglyoxylsäure, 2-Benzoyl-2-phenyl-1,3-dioxolane and 4-Benzoyl-4-phenyl-1,3-dioxolane sowie Photoredoxsysteme, die aus einem Gemisch aus einem Phenothiazinfarbstoff (z. B. Methylenblau) oder einem Chinoxalin (z. B. einem Metallsalz der 2-(m- oder p-Methoxyphenyl)-chinoxalin-6'-oder -7'-sulfonsäure) mit einem Elektronendonator wie Benzolsulfinsäure oder eine anderen Sulfinsäure oder einem Salz davon, wie dem Natriumsalz, oder einem Arsin, einem Phosphin oder Thioharnstoff bestehen.

Geeignete Photoinitiatoren lassen sich leicht durch Serienversuche auffinden. Im allgemeinen werden 0,15 bis 10 Gew.-% und vorzugsweise 2,5 bis 5 Gew.-% Photoinitiator zugegeben, bezogen auf das Gesamtgewicht von (A) und gegebenenfalls einer weiteren Verbindung (B) mit mindestens einer Gruppe der Formel I aber keiner der Formel II. (Zur Verwendung als Verbindung (B) geeignete Substanzen sind weiter unten beschrieben.)

Zur Photovernetzung über Gruppen der Formel II ist es ebenfalls bei weitem vorzuziehen, dass die flüssige Zusammensetzung ferner einen zugesetzten Triplettphotosensibilisator enthält, d. h. eine Verbindung, welche bei Bestrahlung einen angeregten Zustand ergibt, der die Triplettenergie auf eine nicht angeregte 2,3-disubstituierte Maleinimidgruppe der Formel II überträgt. Dabei ist es erforderlich, dass der Triplettsensibilisator ein Absorptionsmaximum besitzt, das Lichtabsorption im Bereich über

300 nm ermöglicht, was für praktische Zwecke genügt; ferner muss die Triplettenergieübertragung exotherm sein. Photopolymerisierte, die 2,3-disubstituierte Maleinimidgruppe der Formel II enthaltende Verbindungen weisen einen $T_1$-Zustand zwischen 50 und 53 kcal/mol auf; somit sind Triplettsensibilisatoren, die exotherme Energieübertragung im erwähnten Bereich ermöglichen, d. h. eine $T_1$-Zustand von mindestens 50 kcal/mol besitzen, zur Sensibilisierung geeignet. Beispiele für geeignete Sensibilisatoren sind Benzol, Phenol, Bensoesäure, Benzonitril, Anilin, Xanthon, Acetophenon, Diisopropylketon, Diphenylsulfid, Diphenylamin, Benzaldehyd, Diphenylselen, Carbazol. Triphenylamin, Hexachlorbenzol, 4,4-Diphenylcyclohexadienon, 1,2-Dibenzoylbenzol, Thiophen, Benzophenon, 1,4-Diacetylbenzol, Fluoren, Triphenylen, 4-Cyanbenzophenon, Diphenyl, Thioxanthon, 2-Chlorthioxanthon, Phenylglyoxal, Anthrachinon, Chinolin, Phenanthren, Flavon, Michlers Keton, Naphthalin, 4-Acethyldiphenyl, Nitrobenzol, 2-Acetonaphthen, Acridingelb, 1-Naphthylphenylketon, Chrysen, 1-Acetonaphthol, 1-Naphthaldehyd, Diacetyl, Coronen, Benzil, Fluorenon, Fluorescein(Säure), p-Nitrostilben, Anthron, Benzanthron, 2-Nitrofluoren, Chinoxalin und Substitutionsprodukte, 4-Nitrodiphenyl, 5-Nitroacenapthen, 4-Nitroanilin, Naphthothiazolin und 1-Acetylamino-4-nitronaphthalin.

Geeignete Photosensibilisatoren lassen sich ebenfalls leicht durch Serienversuche auffinden. Im allgemeinen gibt man 0,1 bis 10 Gew.-% und vorzugsweise 0,5 bis 7,5 Gew.-% Photosensibilisator dazu, berechnet auf das Gesamtgewicht von (A) und gegebenenfalls einer weiteren Verbindung (C), die mindestens eine Gruppe der Formel II aber keine der Formel I enthält.

Bezugnahmen auf Photovernetzung über Gruppen der Formel II sind in dieser Patentschrift nicht so auszulegen, als dass sie die Möglichkeit ausschliessen würden, dass ein geringes Ausmass von Photodimerisierung über Gruppen der Formel II in der Stufe (1) stattfinden könnte; es wird jedoch angenommen, dass die Photopolymerisation in Stufe (1) weit überwiegend nur Gruppen der Formel I betrifft.

Wie oben erwähnt, wird die Zusammensetzung in flüssiger Form auf einen Träger aufgebracht. Zweckmässig liegt ihre Viskosität im Bereich 0,1 bis 0,4 Pa.s. Um das Erfordernis einer flüssigen Zusammensetzung zu erfüllen, kann es nötig sein, um dies ohne Anwendung flüchtiger organischer Lösungsmittel zu erreichen, eine weitere Verbindung mitzuverwenden, die flüssig ist und unter den Bedingungen der Stufe (1) unter Bildung eines Feststoffs photopolymerisiert. Hierfür ist es zweckmässig, eine photopolymerisierbare Verbindung (B) mit mindestens einer Gruppe der Formel I aber keiner der Formel II im Molekül zu verwenden. Die Verbindung (B) kann beispielsweise ein gegebenenfalls substituierter Alkyl- oder Hydroxyalkylester der Acrylsäure oder Methacrylsäure sein, wobei solche Ester insgesamt bis 15 Kohlenstoffatome aufweisen, wie Methylmethacrylat, Aethylmethacrylat, n-Butylacrylat und 2-Hydroxyäthylacrylat. Ebenfalls kommen hierfür die 3-Alkoxy-2-hydroxypropyl-, 3-Alkenoxy-2-hydroxypropyl- und 3-Aryloxy-2-hydroxypropylester der Acrylsäure oder Methacrylsäure in Betracht, wobei diese typischerweise insgesamt bis 15 Kohlenstoffatome enthalten.

Weitere Arten Verbindung (B) können der flüssigen Zusammensetzung zugegeben werden, um dem photopolymerisierten, photovernetzten Produkt gewisse erwünschte Eigenschaften zu verleihen. So kann die Verbindung (B) auch mindestens ein Chlor-, Brom- oder Phosphoratom enthalten, um flammhemmende Eigenschaften zu verleihen. Beispiele dafür sind Acrylsäure- oder Methacrylsäureaddukte mit einem brom- oder chlorsubstituierten Arylglycidyläther wie Dibrom-p-kresyl-glycidyläther, z. B. 3-(Methacryloyloxy)-2-hydroxypropyl-X,Y-dibrom-p-kresyläther.

Wie unten erläutert, kann es wüschenswert sein, Epoxidgruppen in die Zusammensetzung einzuführen, denn nach der Photovernetzung des Produkts lässt sich weitere Vernetzung durch Heisshärtung über die Epoxidgruppen erzielen. Es kann daher vorteilhaft sein, in der flüssigen Zusammensetzung eine photopolymerisierbare Verbindung mitzuverwenden, die im selben Molekül sowohl eine Gruppe der Formel I und nur eine 1,2-Epoxidgruppe aufweist, wie Glycidylacrylat oder Glycidylmethacrylat. Ferner kann man der flüssigen Zusammensetzung vor der Photopolymerisation ein Epoxidharz (d. h. eine mehr als eine Epoxidgruppe enthaltende Verbindung) zufügen.

Gewünschtenfalls kann die flüssige Zusammensetzung ebenfalls eine photopolymerisierbare Verbindung (C) mit mindestens einer Gruppe der Formel II aber keiner der Formel I enthalten, z. B. N-Glycidyl-2,3-dimethylmaleinimid.

Die flüssige Zusammensetzung lässt sich nach herkömmlichen Methoden wie Sprühbeschichtung, Aufschleudern, Walzenauftrag, Kaskadenbeschichtung und insbesondere Vorhangbeschichtung auf geeignete Träger aufbringen. Typischerweise wird der Träger so beschichtet, dass die Schicht der Zusammensetzung 1 bis 250 µm dick ist. Der Träger kann beispielsweise aus Kupfer, Aluminium oder einem anderen Metall, aus Papier, Kunstharz oder Glas bestehen.

Sowohl bei der Photopolymerisationsstufe als auch der nachfolgenden Photovernetzungsstufe des erfindungsgemässen Verfahrens verwendet man vorzugsweise aktinische Strahlung einer Wellenlänge von 200-600 nm. Als aktinische Strahlungsquellen eignen sich unter anderem Kohlelichtbögen, Quecksilberdampflichtbögen, Leuchtröhren mit ultraviolettes Licht ausstrahlenden Leuchtstoffen, Argon- und Xenonglimmlampen, Wolframlampen und photographische Flutlampen. Darunter sind Quecksilberdampflichtbögen, insbesondere Höhensonnen, fluoreszierende Höhensonnen und Metallhalogenidlampen am besten geeignet. Die zur Belichtung der photopolymerisierbaren Zusammensetzung und der noch photovernetzbaren Zusammensetzung erforderlichen Zeiten hängen von verschiedenen Faktoren ab, beispielsweise den individuellen verwendeten Verbindungen, der Art der Lichtquelle und deren Abstand

von der bestrahlten Zusammensetzung. Der mit Photopolymerisationsmethoden vertraute Fachmann kann die geeigneten Zeiten leicht bestimmen; im allgemeinen ist die in der zweiten Stufe (der Photovernetzungsstufe) benötigte Lichtenergiemenge 15- bis 100mal, typischerweise 25- bis 60mal, grösser als in der ersten Stufe. Zum Beispiel wird die Zusammensetzung zunächst im Abstand von 10-25 cm 5-15 Sekunden lang mit einer 500 Watt-Birne bestrahlt; in der zweiten Stufe wird sie 10-20 Minuten lang im Abstand von 15-30 cm bestrahlt. Mit stärkeren Strahlungsquellen, z. B. 5 Kilowatt, können die Bestrahlungszeiten, besonders in der zweiten Stufe, viel kürzer sein.

Die zur Verwendung als Verbindung (A) bevorzugten Substanzen enthalten nur eine Gruppe der Formel I pro Molekül, doch wurden befriedigende Ergebnisse mit mehr als eine solche Gruppe enthaltenden Substanzen erzielt. Bei Verwendung von Diacrylaten, Dimethacrylaten und anderen mehr als eine Gruppe der Formel I enthaltenden Substanzen soll die Belichtung mit aktinischer Strahlung in Stufe (1) begrenzt sein, damit eventuelle Vernetzung über Gruppen der Formel I in dieser Stufe nicht so weit fortschreitet, dass die Erzeugung einer Abbildung in Stufe (3) erheblich gehemmt wird.

Zum Entwickeln der Abbildung geeignete Lösungsmittel lassen sich leicht durch Serienversuche auffinden; dies sind unter anderem Cyclohexanon, Trimethylcyclohexanon, 2-Aethoxyäthanol, 1,1,1-Trichloräthan, Benzylalkohol, Methylenchlorid und deren Gemische. Es kann notwendig sein, die Wirkung des Lösungsmittels durch Rühren oder leichtes Bürsten zu unterstützen. Besitzt der Träger eine Schicht eines geeigneten elektrisch leitenden Metalls, üblicherweise Kupfer oder Silber, in direkter Berührung mit der photopolymerisierten Zusammensetzung, so kann das unvernetzte Polymer durch Entwicklung entfernt werden, um das Metall freizulegen. So freigelegtes Metall kann dann an den Nichtbildstellen mitells Aetzflüssigkeiten wie Ferrichlorid- oder Ammoniumpersulfatlösungen weggeätzt werden, um eine gedruckte Schaltung zu bilden.

Gewünschtenfalls kann man in der flüssigen Zusammensetzung eine Verbindung (B) mitverwenden, welche mindestens eine freie Sulfon- oder Phosphorsäuregruppe oder insbesondere mindestens eine freie Carboxylgruppe aufweist; zweckmässig ist dies Acrylsäure oder Methacrylsäure oder ein Anlagerungsprodukt eines Hydroxyalkylacrylats oder -methacrylats mit Trimellithsäureanhydrid, d. h. eine Verbindung der Formel

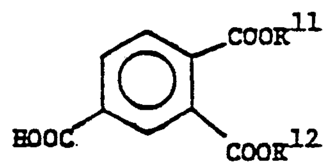

(XXVII)

worin $R^{11}$ entweder ein Wasserstoffatom bedeutet, in welchem Fall $R^{12}$ dann eine Gruppe der Formel

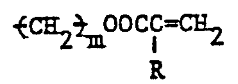

(XXVIII)

oder

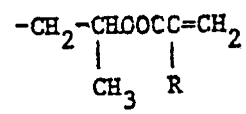

(XXIX)

darstellt, oder $R^{11}$ bedeutet eine Gruppe der Formel XXVIII oder XXIX, in welchem Fall $R^{12}$ dann ein Wasserstoffatom darstellt, wobei R die unter Formel I und m die unter Formel XII angegebenen Bedeutungen haben.

Anstelle von oder zusätzlich zu einer solchen Verbindung (B) kann man eine carboxylhaltige Verbindung (A) der Formel XVII, worin $R^8$ ein Wasserstoffatom bedeutet, einsetzen.

Die Gegenwart freier Sulfon-, Phosphor- oder Carbonsäuregruppen im photopolymerisierten Polymer hat zur Folge, dass man zur Entwicklung eine wässrige Lösung einer Base, wie verdünnte Natronlauge, Natriumcarbonat-, Dinatriumhydrogenorthophosphat- oder Ammoniaklösungen verwenden kann, wodurch die Anwendung organischer Lösungsmittel in dieser Stufe vermieden wird.

Andererseits kann man in der flüssigen Zusammensetzung auch eine Verbindung (B) mitverwenden, welche mindestens eine primäre, sekundäre oder tertiäre Aminogruppe trägt. Als Folge der Gegenwart freier Aminogruppen im photopolymerisierten Polymer kann man wässrige Säurelösungen wie verdünnte Mineralsäurelösungen als Entwickler einsetzen. Beispiele für solche Verbindungen (B) sind Alkylester der Acryl- oder Methacrylsäure, deren Alkylgruppen durch eine sekundäre oder tertiäre Aminogruppe substituiert sind, wie 2-(Dimethylamino)-äthyl-methacrylat.

Wie bereits angegeben kann die Zusammensetzung nach der Photopolymerisation und Photovernetzung ein Epoxidharz enthalten, wobei sie dann ferner einen latenten Heisshärter für das Epoxidharz enthalten kann, so dass die Zusammensetzung erhitzt werden und zusätzliche Vernetzung eintreten kann, um die beständigkeit des photovernetzten Produkte gegen Lösungsmittel und hohe Temperaturen weiter zu erhöhen. Wie schon angegeben kann das Epoxidharz also solches in die Zusammensetzung eingearbeitet oder an Ort und Stelle durch Photopolymerisation einer zusätzlich nur eine 1,2-Epoxidgruppe im gleichen Molekül enthaltenden Verbindung (B) gebildet werden. Latente Heisshärter für Epoxidharze sind beispielsweise Polycarbonsäureanhydride wie Hexahydrophthalsäureanhydrid, Dicyandiamid, Bortrifluorid- oder Bortrichloridkomplexe von Aminen wie Aethylamin, Trimethylamin and n-Octyldimethylamin, latente Bordifluoridchelate, aromatische Polyamine wie Bis-(p-aminophenyl)-methan und Bis-(p-aminophenyl)-sulfon, aromatische Biguanide wie 2,6-Xylidenbiguanid und Imidazole wie 2-Aethyl-4-methylimidazol oder 2-Phenylimidazol.

Die nachfolgenden Beispiele erläutern die Erfindung. Falls nicht anders angegeben, sind Teile und Prozentangaben Gewichtsteile und Gewichtsprozente. Die in den Beispielen verwendeten Substanzen werden wie folgt hergestellt:

N-(2-(Acryloyloxy)-äthyl)-2,3-dimethylmaleinimid
N-(2-(Methacryloyloxy)-äthyl)-2,3-dimethylmaleinimid

Diese stellt man aus N-(2-(Hydroxyäthyl)-2,3-dimethylmaleinimid und Acryloyl- bzw. Methacryloylchlorid analog der in Beispiel 17 der britischen Patentschrift Nr. 1 544 840 beschriebenen Methode zur Herstellung des 3-(Methacryloyloxy)-propylhomologen her.

N-(2-(2-Methacryloyloxy)-äthoxy)-äthyl)-2,3-dimethylmaleinimid

Man erhält dieses durch Umsetzung von 2,3-Dimethylmaleinsäureanhydrid mit 2-(2-Hydroxyäthoxy)-äthylamin und Veresterung des so gebildeten N-(2-(Hydroxyäthoxy)-äthyl)-2,3-dimethylmaleinimids mit Methacryloylchlorid.

2-(Acryloyloxy)-äthyl-3-(methacryloyloxy)-2-hydroxypropyl-X-(2,3-dimethylmaleinimido)-phthalate

Man versetzt ein Gemisch von 3- und 4-(2,3-Dimethylmaleinimido)-phthalsäureanhydrid (54,2 g), 2-Hydroxyäthylacrylat (26 g) und Tetrahydrofuran (500 ml) mit Triäthylamin (1 ml) und Hydrochinon (0,2 g) und erhitzt unter Stickstoff 24 Stunden bei 50 °C unter Rühren. Dann tropft man während 1 Stunde Glycidylmethacrylat (28,4 g) dazu und erhitzt noch weitere 24 Stunden bei 50 °C unter Rühren. Durch Destillation auf dem Wasserbad unter vermindertem Druck entfernt man das Tetrahydrofuran, nimmt den Rückstand in Diäthyläther (500 ml) auf und filtriert die Lösung. Das Filtrat wird mit 0,5n wässriger Natronlauge (100 ml) und dann zweimal mit Wasser (je 250 ml) gewaschen und über wasserfreiem Magnesiumsulfat getrocknet. Nach Filtrieren und Abdampfen erhält man ungefähr 56 g gemischte Isomere der Formel

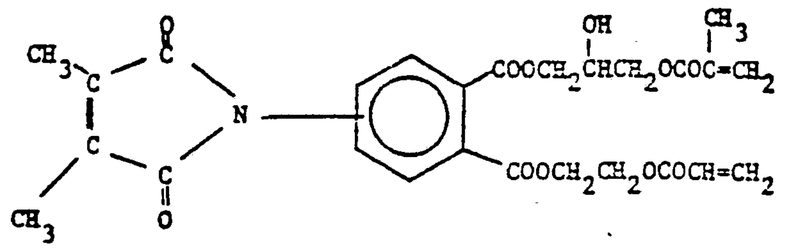

(XXX)

3-(Methacryloyloxy)-2-hydroxypropyl-X,Y-dibrom-p-kresyläther

Man versetzt 250 g handelsüblichen X,Y-Dibrom-p-kresyl-glycidyläther (Epoxidgehalt 2,76 val/kg, berechnet 3,11) mit 2,6-Di-tert.-butyl-p-kresol (0,5) und 1 g Tretramethylammoniumchlorid und erhitzt die Lösung unter Rühren auf 100 °C. Dann gibt man im Verlauf von 1 Stunde Methacrylsäure (59,3 g) langsam mit einer solchen Geschwindigkeit zu, dass die Temperatur des Gemischs 105 °C nicht übersteigt. Man erhitzt bei 100 °C weiter, bis der Epoxidgehalt auf einen vernachlässigbar kleinen Wert gefallen ist. Das Produkt ist eine klare viskose Flüssigkeit.

Gemischte 3-(Methacryloyloxy)-2-hydroxypropyl-kresyläther

Dieses Gemisch wird auf ähnliche Weise aus gemischten o-, m- und p-Kresyl-glycidyläthern hergestellt.

Herstellung von n-(p-(Acryloylamino)-phenyl)-2,3-dimethylmaleinimid

Man gibt Acryloylchlorid (27,2 g) unter Rühren zu einer in Aceton/Kohlensäureschnee gekühlten Lösung von N-(p-Aminophenyl)-2,3-dimethylmaleinimid (21,6 g) in Pyridin (300 ml) mit einer solchen Geschwindigkeit, dass die Temperatur auf 5 bis 10 °C gehalten wird. Man lässt die Lösung sich auf Raumtemperatur erwärmen, rührt 2 Stunden und setzt dann einen grossen Ueberschuss Eis dazu. Das kalte Gemisch wird bei − 10 °C mit konzentrierter Salzsäure versetzt. Um den Ueberschuss Pyridin als Hydrochlorid zu entfernen, wird die Lösung gründlich in Dichlormethan extrahiert. Nach Abdampfen des Lösungsmittels erhält man 9,5 g des gewünschten Amid-imids.

Beispiel 1

Eine aus 45 Teilen N-(2-(Methacryloyloxy)-äthyl)-2,3-dimethylmaleinimid, 45 Teilen gemischten 3-(Methacryloyloxy)-2-hydroxypropyl-kresyläthern, 8 Teilen Benzildimethylketal und 2 Teilen 2-Chlorthioxanthon bestehende Zusammensetzung stellt man dadurch her, dass man die Methacrylate bei etwa 50 °C zusammen erhitzt und dann den Photoinitiator und den Photosensibilisator zwecks Auflösung einrührt. Diese Zusammensetzung mit einer Viskosität von etwa 0,25 Pa.s wird mittels eines Schleuderauftragsgeräts als ungefähr 20 µm dicke Schicht auf eine Kupferplatte aufgebracht. Man bestrahlt die Beschichtung 15 Sekunden mit einer Mitteldruckquecksilberlampe (80 W pro cm) im Abstand von 20 cm, wobei die Beschichtung klebfrei wird.

Danach bestrahlt man die Beschichtung durch ein Negativ hindurch im Abstand von 25 cm 10 Minuten lang mit einer Mitteldruckquecksilberlampe (30 W pro cm) und entwickelt anschliessend mit Cyclohexanon. Man erhält eine gute Reliefabbildung.

Beispiel 2

Man verfährt wie in Beispiel 1, unter Verwendung einer Zusammensetzung, die eine Viskosität von etwa 0,3 Pa.s aufweist und aus 25 Teilen N-(2-(Methacryloyloxy)-äthyl)-2,3-dimethylmaleinimid, 56 Teilen 3-(Methacryloyloxy)-2-hydroxypropyl-X,Y-dibrom-p-kresyläther, 11 Teilen Glycidylmethacrylat, 7 Teilen Benzildimethylketal und 2 Teilen 2-Chlorthioxanthon besteht. Die Beschichtung wird 10 Sekunden in der ersten Stufe und 15 Minuten in der zweiten Stufe bestrahlt. Die Abbildung wird unter Rühren und Bürsten in einem Gemisch aus gleichen Volumenteilen 1,1,1-Trichloräthan und Cyclohexanon entwickelt. Man erhält eine gute Reliefabbildung.

Beispiel 3

Man verfährt wie in Beispiel 1, unter Verwendung einer aus 41,7 Teilen N-(2-(Methacryloyloxy)-äthyl)-2,3-dimethylmaleinimid, 41,7 Teilen 3-(Methacryloyloxy)-2-hydroxypropyl-X,Y-dibrom-p-kresyläther, 10 Teilen Glycidylmethacrylat, 5 Teilen Benzildimethylketal und 1,5 Teilen 2-Chlorthioxanthon bestehenden Zusammensetzung. Die 15 µm dicke Beschichtung wird im Abstand von 3 cm 15 Sekunden lang in der ersten Stufe und im Abstand von 25 cm 45 Sekunden lang in der nächsten Stufe mit einer 5 000 Watt-Metallhalogenidlampe bestrahlt. Bei Entwicklung mit Benzylalkohol erhält man eine gute Abbildung.

Beispiel 4

Man verfährt wie in Beispiel 1, unter Verwendung einer aus 30 Teilen N-(2-(2-(Methacryloyloxy)-äthoxy)-äthyl)-2,3-dimethylmaleinimid, 50 Teilen 3-(Methacryloyloxy)-2-hydroxypropyl-X,Y-dibrom-p-kresyläther, 20 Teilen Glycidylmethacrylat, 4 Teilen Benzildimethylketal und 2 Teilen 2-Chlorthioxanthon bestehenden, als 4 µm dicke Beschichtung aufgebrachten Zusammensetzung. Bei 10 Sekunden Bestrahlung in der ersten Stufe wird die Beschichtung klebfrei.

Beispiel 5

Ein aus 40 Teilen 2-(Acryloyloxy)-äthyl-3-(methacryloyloxy)-2-hydroxypropyl-X-(2,3-dimethylmaleinimido)-phthalaten, 2,4 Teilen Benzildimethylketal, 1,2 Teilen 2-Chlorthioxanthon und 10 Teilen Glycidylmethacrylat bestehendes Gemisch in Form einer Beschichtung auf einer Kupferplatte wird 40 Sekunden lang im Abstand von 20 cm mit einer Mitteldruckquecksilberlampe (80 W pro cm) bestrahlt, wobei man eine klebfreie Beschichtung erhält. Bei 15 Minuten langer Bestrahlung im Abstand von 25 cm mit einer Mitteldruckquecksilberlampe (30 W pro cm) und nachfolgender Entwicklung mit Aceton/Toluol (1 : 9 Vol./Vol) entsteht eine Abbildung.

Beispiel 6

In diesem Beispiel enthält die Formulierung einen Farbstoff, so dass die Abbildung deutlich sichtbar ist.

Ein 30 Teile N-(2-(Acryloyloxy)-äthyl)-2,3-dimethylmaleinimid, 60 Teile 3-(Methacryloyloxy)-2-hydroxypropyl-X,Y-dibrom-p-kresyläther, 7,5 Teile Benzildimethylketal, 1,7 Teile 2-Chlorthioxanthon und 0,6 Teil eines methacrylathaltigen Farbstoffs der Formel

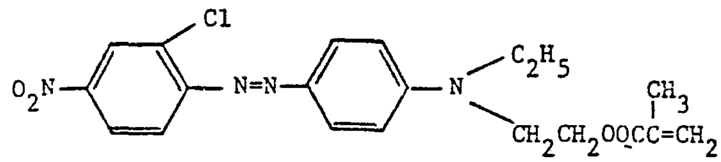

(XXXI)

enthaltendes Gemisch wird auf eine Kupferplatte aufgebracht und unter denselben Bedingungen wie in Beispiel 1 bestrahlt, ausser dass man die erste Bestrahlungszeit auf 7 Sekunden verringert und ein Gemisch aus 1,1,1-Trichloräthan und Cyclohexanon (2 : 1 Vol./Vol.) zum Entwicklen verwendet. Man erhält eine gute Reliefabbildung.

Beispiel 7

Man verfährt wie in Beispiel 6, unter Ersatz des N-(2-(Acryloyloxy)-äthyl)-2,3-dimethylmaleinimids durch eine gleiche Gewichtsmenge N-(2-(Methacryloyloxy)-äthyl)-2,3-dimethylmaleinimid, wobei man ähnliche Ergebnisse erhält.

Beispiel 8

In diesem Beispiel enthält die Formulierung Methacrylsäure, so dass die Abbildung mit einer wässrigen basischen Lösung entwickelt werden kann.

Eine aus 23 Teilen N-(2-(Acryloyloxy)-äthyl)-2,3-dimethylmaleinimid, 23 Teilen Methacrylsäure, 46 Teilen 3-(Methacryloyloxy)-2-hydroxypropyl-X,Y-dibrom-p-kresyläther, 6 Teilen Benzildimethylketal und 2 Teilen 2-Chlorthioxanthon bestehende Zusammensetzung wird wie in Beispiel 2 beschrieben bestrahlt und dann mit 0,1 m wässriger Natronlauge entwickelt. Man erhält eine gute Reliefabbildung.

Beispiel 9

In diesem Beispiel enthält die Formulierung 2-(Diäthylamino)-äthylacrylat, so dass die Abbildung mit einer wässrigen sauren Lösung entwickelt werden kann.

Eine aus 30 Teilen N-(2-(2-(Methacryloyloxy)-äthoxy)-äthyl)-2,3-dimethylmaleinimid, 20 Teilen 3-(Methacryloyloxy)-2-hydroxypropyl-X,Y-dibrom-p-kresyläther, 50 Teilen 2-(Diäthylamino)-äthylacrylat, 3 Teilen Benzildimethylketal und 1,5 Teilen 2-Chlorthioxanthon bestehende Zusammensetzung wird als 4 µm dicke Beschichtung auf eine Kupferplatte aufgebracht. Die Beschichtung wird 10 Sekunden im Abstand von 20 cm mit einer Mitteldruckquecksilberlampe (80 W pro cm) bestrahlt, wobei sie klebfrei wird. Nach 20 Minuten langer Bestrahlung der Beschichtung mit einer Mitteldruckquecksilberlampe (30 W pro cm) im Abstand von 25 cm durch ein Negativ hindurch wird die Abbildung mit 1m Salzsäure entwickelt.

Beispiel 10

In diesem Beispiel enthält die Zusammensetzung einen latenten Härter für Epoxidharze, so dass die entwickelte Abbildung hiesshärtbar ist.

Ein Gemisch, das eine Viskosität von ungefähr 0,3 Pa.s aufweist und aus 25 Teilen N-(2-(Methacryloyloxy)-äthyl-2,3-dimethylmaleinimid, 52 Teilen 3-(Methacryloyloxy)-2-hydroxypropyl-X,Y-dibrom-p-kresyläther, 12 Teilen Glycidylacrylat, 6 Teilen Benzildimethylketal, 2 Teilen 2-Chlorthioxanthon und 3 Teilen 2,6-Xylindenbiguanid besteht, wird wie in Beispiel 1 beschrieben auf eine Kupferplatte aufgebracht und dann unter den zwei unterschiedlichen dort beschriebenen Bedingungen bestrahlt. Nach Entwickeln mit Cyclohexanon wird die Platte zur Heisshärtung des Produkts über seine Epoxidgruppen 1 Stunde auf 170 °C erhitzt.

Beispiel 11

Ein aus 50 Teilen n-[p-(Acryloylamino)-phenyl]-2,3-dimethylmaleinimid, 100 Teilen Glycidylacrylat, 6 Teilen Benzildimethylketal und 3 Teilen 2-Chlorthioxanthon bestehendes Gemisch wird wie in Beispiel 1 aufgebracht, wobei man jedoch die Schicht in der ersten Stufe 60 Sekunden lang und in der zweiten Stufe 30 Minuten lang bestrahlt. Beim Entwickeln mit 1,1,1-Trichloräthan unter Bürsten erhält man eine Abbildung.

Vergleichsbeispiel

Nur zu Vergleichszwecken wird eine 60 Teile N-(3-Hydroxypropyl)-2-3-dimethylmaleinimid, 64 Teile 3-(Methacryloyloxy)-2-hydroxypropyl-X,Y-dibrom-p-kresyläther, 10 Teile 2-Hydroxyäthylmethacrylat, 10 Teile Benzildimethylketal und 5 Teile 2-Chlorthioxanthon enthaltende Zusammensetzung hergestellt.

Diese Zusammensetzung wird als 10 µm dicke Beschichtung auf einen kupferkaschierten Epoxidharz/Glasfaserschichtkörper augebracht und 25 Sekunden lang mit einer Mitteldruckquecksilberlampe (80 W pro cm) bestrahlt, wobei man einem klebfreien Film erhält. Weitere Vernetzung durch nachfolgende, 20 Minuten lange Bestrahlung mit einer Mitteldruckquecksilberlampe (30 W/cm) durch ein photographisches Negativ hindurch ist jedoch nicht durchführbar, denn der ganze Film löst sichbeim Eintauchen in Cyclohexanon auf.

**Patentansprüche**

1. Verfahren zur Erzeugung einer Abbildung, dadurch gekennzeichnet, dass man

(1) eine auf einem Träger aufgebrachte Schicht aus einer flüssigen Zusammensetzung, die eine Verbindung (A) mit sowohl mindestens einer Gruppe der Formel I.

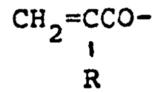

(I)

als auch mindestens einer Gruppe der Formel

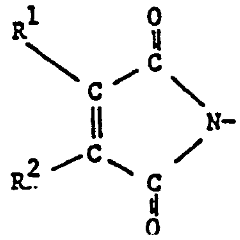

(II)

im selben Molekül enthält, wobei R ein Wasserstoffatom oder eine Methylgruppe bedeutet sowie $R^1$ und $R^2$ gleich oder verschieden sind und je eine Alkylgruppe mit 1 bis 4 Kohlenstoffatomen oder zusammen eine gegebenenfalls durch eine Methylgruppe substituierte Trimethylen- oder Tetramethylengruppe darstellen, so mit aktinischer Strahlung belichtet, dass sich die Schicht durch Photopolymerisation von (A) über die Gruppe bzw. Gruppen der Formel I verfestigt und im wesentlichen klebfrei wird, jedoch weitgehend photovernetzbar bleibt, und anschliessend

(2) die so verfestigte Schicht durch eine bildtragende Vorlage mit weitgehend undurchsichtigen und weitgehend durchsichtigen Stellen hindurch mit einer wesentlich grösseren Menge aktinischer Strahlung belichtet, so dass die weiterbelichtete(n) Stelle(n) der photopolymerisierten Schicht über die Gruppe bzw. Gruppen der Formel II Photovernetzung eingehen, und

(3) die Abbildung durch Auflösung der nicht photovernetzten Stelle der Schicht in einem Lösungsmittel entwickelt.

2. Verfahren nach Anspruch 1, dadurch gekennzeichnet, dass (A) pro Durchschnittsmolekül bis zu vier Gruppen der Formel I enthält.

3. Verfahren nach Anspruch 1 oder 2, dadurch gekennzeichnet, dass (A) pro Durchschnittsmolekül bis zu vier Gruppen der Formel II enthält.

4. Verfahren nach einem der vorhergehenden Ansprüche, dadurch gekennzeichnet, dass die Gruppe(n) der Formel I direkt an ein Kohlenstoff-, Sauerstoff- oder Stickstoffatom bzw. -atome gebunden ist bzw. sind.

5. Verfahren nach einem der vorhergehenden Ansprüche, dadurch gekennzeichnet, dass die Gruppe(n) der Formel II direkt an ein Kohlenstoff-, Sauerstoff- oder Stickstoffatom bzw. -atome gebunden ist bzw. sind.

6. Verfahren nach einem der Ansprüche 1 bis 3, dadurch gekennzeichnet, dass (A) der Formel

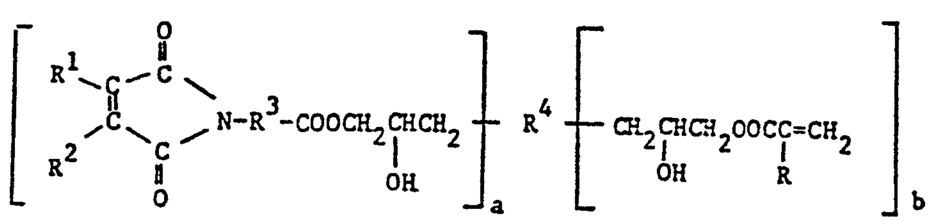

(IV)

entspricht, worin a und b unabhängig voneinander eine ganze Zahl von mindestens 1 sind, R, $R^1$ und $R^2$ die in Anspruch 1 angegebenen Bedeutungen haben, $R^3$ nach Wegnahme einer primären Aminogruppe und einer Carboxylgruppe den zweiwertigen Rest einer mindestens eine solche Aminogruppe und mindestens eine Carboxylgruppe enthaltenden Verbindung darstellt und $R^4$ nach Wegnahme von (a + b) direkt an ein Sauerstoff-, Stickstoff- oder Schwefelatom bzw. -atome gebundenen Glycidylgruppen den Rest einer mindestens (a + b) solche Glycidylgruppen enthaltenden Verbindung bedeutet.

7. Verfahren nach einem der Ansprüche 1 bis 3, dadurch gekennzeichnet, dass (A) der Formel

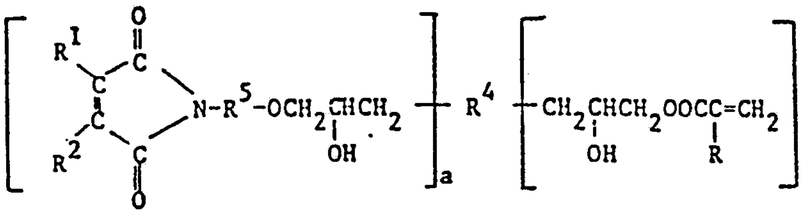

(VIII)

entspricht, worin a und b je die in Anspruch 6, R, $R^1$ und $R^2$ die in Anspruch 1 und $R^4$ die in Anspruch 6 angegebenen Bedeutungen haben und $R^5$ nach Wegnahme einer primären Aminogruppe und einer phenolischen Hydroxylgruppe den zweiwertigen Rest einer mindestens eine solche Aminogruppe und mindestens eine solche Hydroxylgruppe enthaltenden Verbindung darstellt.

8. Verfahren nach einem der Ansprüche 1 bis 3, dadurch gekennzeichnet, dass (A) der Formel

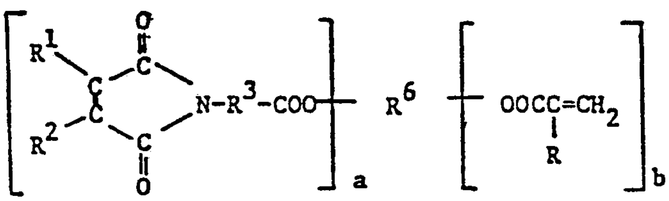

(XI)

entspricht, worin a und b je die in Anspruch 6, R, $R^1$ und $R^2$ die in Anspruch 1 und $R^3$ die in Anspruch 6 angegebenen Bedeutungen haben und $R^6$ nach Wegnahme von (a + b) alkoholischen Hydroxylgruppen den Rest eines Alkohols mit mindestens (a + b) solchen Hydroxylgruppen darstellt.

9. Verfahren nach Anspruch 1, dadurch gekennzeichnet, dass (A) der allgemeinen Formel

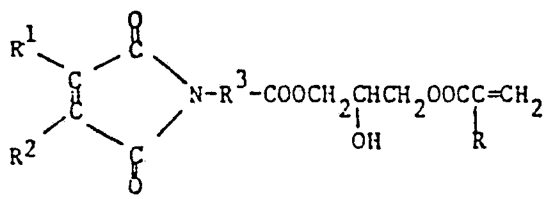

(XIV)

entspricht, worin R, $R^1$ und $R^2$ die in Anspruch 1 und $R^3$ die in Anspruch 6 angegebenen Bedeutungen haben.

10 Verfahren nach Anspruch 1, dadurch gekennzeichnet, dass (A) der allgemeinen Formel

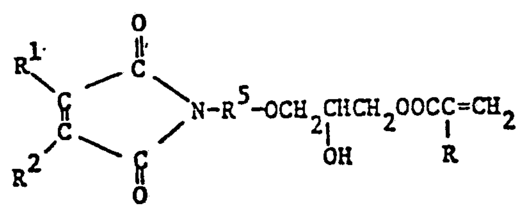

(XV)

entspricht, worin R, $R^1$ und $R^2$ die in Anspruch 1 und $R^5$ die in Anspruch 7 angegebenen Bedeutungen haben.

11. Verfahren nach Anspruch 1, dadurch gekennzeichnet, dass (A) der allgemeinen Formel

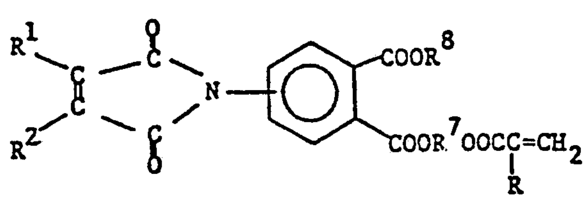

(XVII)

entspricht, worin R, $R^1$ und $R^2$ die in Anspruch 1 angegebenen Bedeutungen haben, $R^7$ eine Alkylengruppe mit 2 oder 3 Kohlenstoffatomen darstellt und $R^8$ ein Wasserstoffatom oder eine Gruppe der Formel

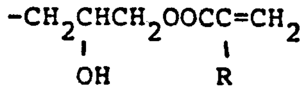

(XVIII)

oder

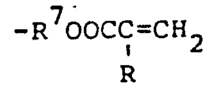

(XIX)

bedeutet.

12. Verfahren nach Anspruch 1, dadurch gekennzeichnet, dass (A) der allgemeinen Formel

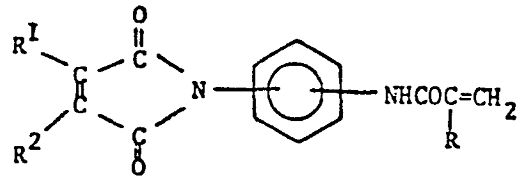

(XX)

entspricht, worin R, $R^1$ und $R^2$ die in Anspruch 1 angegebenen Bedeutungen haben.

13. Verfahren nach Anspruch 1, dadurch gekennzeichnet, dass (A) der allgemeinen Formel

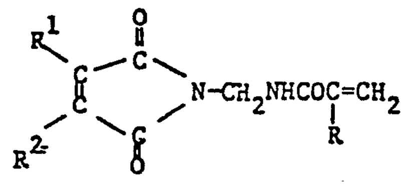

(XXI)

entspricht, worin R, $R^1$ und $R^2$ die in Anspruch 1 angegebenen Bedeutungen haben.

14. Verfahren nach Anspruch 1, dadurch gekennzeichnet, dass (A) der allgemeinen Formel

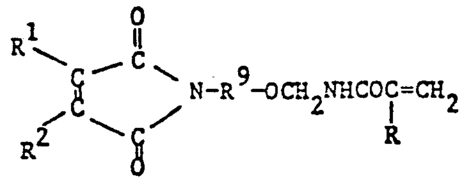

(XXII)

entspricht, worin R, $R^1$ und $R^2$ die in Anspruch 1 angegebenen Bedeutungen haben und $R^9$ nach Wegnahme einer primären Aminogruppe und einer alkoholischen Hydroxylgruppe den zweiwertigen Rest einer mindestens eine solche Aminogruppe und mindestens eine solche Hydroxylgruppe enthaltenden Verbindung darstellt.

15. Verfahren nach Anspruch 1, dadurch gekennzeichnet, dass (A) der allgemeinen Formel

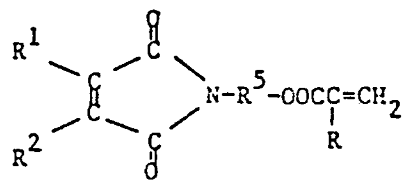

(XXIV)

entspricht, worin R, $R^1$ und $R^2$ die in Anspruch 1 und $R^5$ die in Anspruch 7 angegebenen Bedeutungen haben.

16. Verfahren nach Anspruch 1, dadurch gekennzeichnet, dass (A) der allgemeinen Formel

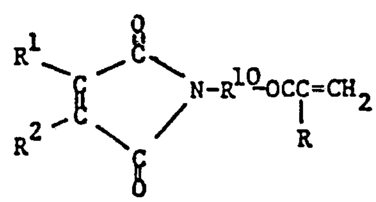

(XXV)

entspricht, worin R, $R^1$ und $R^2$ die in Anspruch 1 angegebenen Bedeutungen haben und $R^{10}$ eine Iminogruppe, eine Alkylenoxygruppe mit 1 bis 10 Kohlenstoffatomen, eine 2-Hydroxypropylenoxygruppe, eine Poly-(oxyalkylen)-gruppe mit 4 bis 12 Kohlenstoffatomen, eine Cycloalkenoxygruppe mit 5 bis 7 Kohlenstoffatomen oder eine Alkylencarbonamidogruppe mit 2 bis 10 Kohlenstoffatomen darstellt.

17. Verfahren nach einem der vorhergehenden Ansprüche, dadurch gekennzeichnet, dass $R^1$ und $R^2$ je eine Methylgruppe bedeuten.

18. Verfahren nach Anspruch 17, dadurch gekennzeichnet, dass (A) N-2-(Acryloyloxy)-äthyl-2,3-dimethylmaleinimid, N-(3-(Acryloyloxy)-2-hydroxypropyl)-2,3-dimethylmaleinimid, N-(3-(Acryloyloxy)-propyl)-2,3-dimethylmaleinimid, N-(2-(Methacryloyloxy)-äthyl)-2,3-dimethylmaleinimid, N-(3-(Methacryloylo-

xy)-2-hydroxypropyl)-2,3-dimethylmaleinimid, N-(3-(Methacryloyloxy)-propyl)-2,3-dimethyl-maleinimid oder N-(2-(2-Methacryloyloxy)-äthoxy)-äthyl)-2,3-dimethylmaleinimid ist.

19. Verfahren nach Anspruch 1, dadurch gekennzeichnet, dass die Zusammensetzung als (A) eine Verbindung der in Anspruch 11 definierten Formel XVII enthält, worin $R^8$ für ein Wasserstoffatom steht, und das zum Entwickeln verwendete Lösungsmittel eine wässrige Lösung einer Base ist.

20. Verfahren nach einem der Ansprüche 1 bis 18, dadurch gekennzeichnet, dass die Zusammensetzung zusätzlich eine photopolymerisierbare Verbindung (B) mit mindestens einer Gruppe der Formel I aber keiner der Formel II sowie mindestens einer freien Sulfon-, Phosphon- oder Carbonsaüregruppe im Molekül enthält und das zum Entwickeln verwendete Lösungsmittel eine wässrige Lösung einer Base ist.

21. Verfahren nach einem der Ansprüche 1 bis 18, dardurch gekennzeichnet, dass die Zusammensetzung eine photopolymerisierbare Verbindung (B) mit mindestens einer Gruppe der Formel I aber keiner der Formel II sowie mindestens einer primären, sekundären oder tertiären Aminogruppe im Molekül enthält und das verwendete Lösungsmittel eine wässrige Lösung einer Säure ist.

**Claims**

1. A process for the production of an image which comprises

(1) exposing to actinic radiation a layer, supported on a carrier, of a liquid composition containing a compound (A) having in the same molecule both at least one group of formula

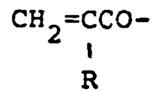 (I)

and at least one group of formula

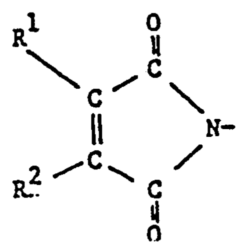 (II)

in which formulae R is a hydrogen atom or a methyl group and $R^1$ and $R^2$ are each the same or different alkyl group of 1 to 4 carbon atoms or together they denote a trimethylene or tetramethylene group which may be substituted by a methyl group, such that the layer solidifies and becomes essentially nontacky due to photopolymerisation of (A) through the group or groups of formula I but remains substantially photocrosslinkable, and subsequently

(2) exposing the layer so solidified through an imagebearing transparency consisting of substantially opaque and substantially transparent parts to a substantially greater amount of actinic radiation such that the further exposed part or parts of the photopolymerised layer undergo photocrosslinking through the group or groups of formula II, and

(3) developing the image by dissolving in a solvent the part or parts of the layer which have not become photocrosslinked.

2. A process according to claim 1, in which (A) contains, per average molecule, up to four groups of formula I.

3. A process according to either claim 1 or claim 2, in which (A) contains, per average molecule, up to four groups of formula II.

4. A process according to any one of the preceding claims, in which the group or groups of formula I is or are directly attached to an atom or atoms of carbon, oxygen, or nitrogen.

5. A process according to any of the preceding claims, in which the group or groups of formula II is or are directly attached to an atom or atoms of carbon, oxygen, or nitrogen.

6. A process according to any one of claims 1 to 3, in which (A) is of the formula

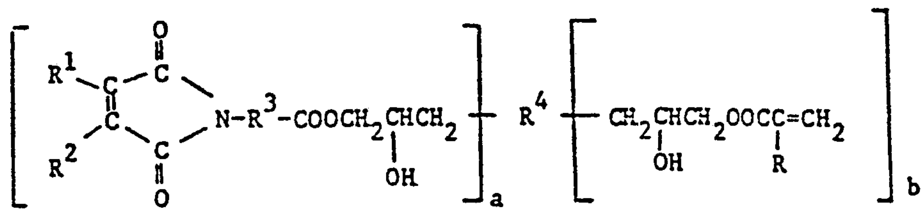 (IV)

wherein a and b are each independently an integer of at least 1, R, $R^1$, and $R^2$ are as defined in claim 1, $R^3$ is, after removal of a primary amino group and a carboxyl group, a divalent residue of a compound

containing at least one said amino group and at least one carboxyl group, and $R^4$ is, after removal of (a + b) glycidyl groups directly attached to an atoms or atoms of oxygen, nitrogen, or sulphur, the residue of a compound containing at least (a + b) such glycidyl groups.

7. A process according to any one of claims 1 to 3, in which (A) is of the formula

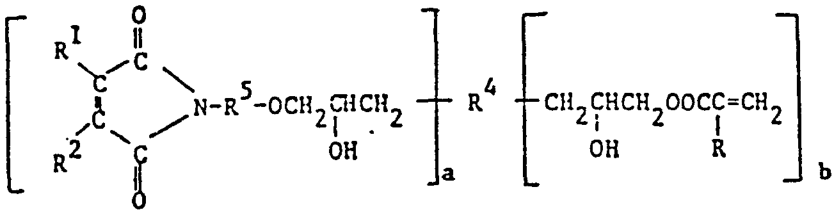
(VIII)

wherein a and b are each as defined in claim 6, R, $R^1$, and $R^2$ are as defined in claim 1, $R^4$ is as defined in claim 6, and $R^5$ is, after removal of a primary amino group and a phenolic hydroxyl group, the divalent residue of a compound containing at least one said amino group and at least one said hydroxyl group.

8. A process according to any one of claims 1 to 3, in which (A) is of the formula

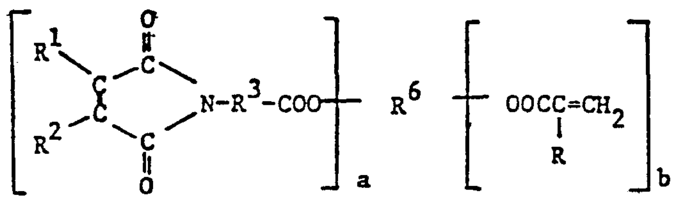
(XI)

wherein a and b are each as defined in claim 6, R, $R^1$, and $R^2$ are as defined in claim 1, $R^3$ is as defined in claim 6, and $R^6$ is, after removal of (a + b) alcoholic hydroxyl groups, the residue of an alcohol having at least (a + b) said hydroxyl groups.

9. A process according to claim 1, in which (A) is of the general formula

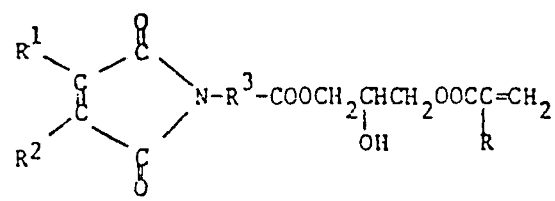
(XIV)

wherein R, $R^1$ and $R^2$ are as defined in claim 1 and $R^3$ is as defined in claim 6.

10. A process according to claim 1, in which (A) is of the general formula

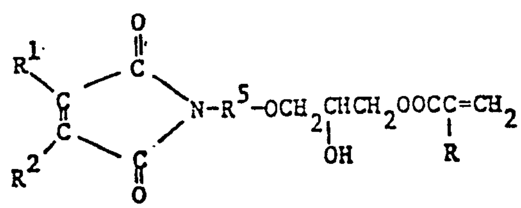
(XV)

wherein R, $R^1$, and $R^2$ are as defined in claim 1 and $R^5$ is as defined in claim 7.

11. A process according to claim 1, in which (A) is of the general formula

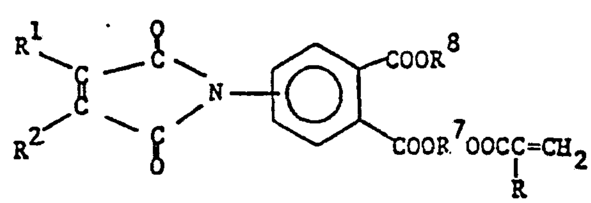
(XVII)

wherein R, $R^1$, and $R^2$ are as defined in claim 1, $R^7$ is an alkylene group of 2 or 3 carbon atoms, and $R^8$ is a hydrogen atom or a group of formula

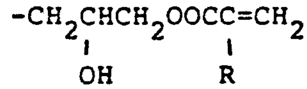
(XVIII)

or

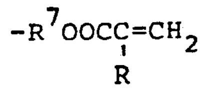 (XIX)

12. A process according to claim 1, in which (A) is of the general formula

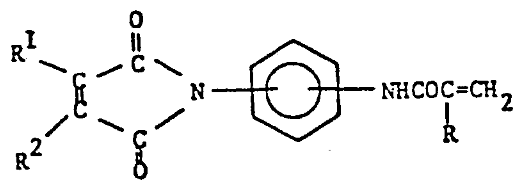 (XX)

wherein R, $R^1$, and $R^2$ are as defined in claim 1.

13. A process according to claim 1, in which (A) is of the general formula

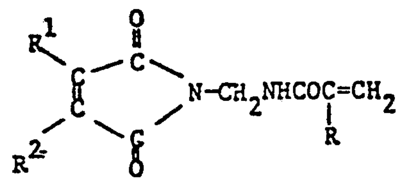 (XXI)

wherein R, $R^1$, and $R^2$ are as defined in claim 1.

14. A process according to claim 1, in which (A) is of the general formula

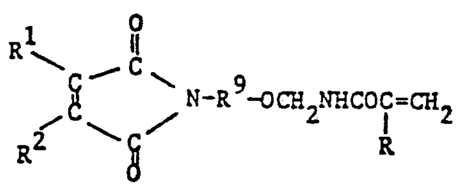 (XXII)

wherein R, $R^1$ and $R^2$ are as defined in claim 1 and $R^9$ is, after removal of a primary amino group and an alcoholic hydroxyl group, the divalent residue of a compound containing at least one said amino group and at least one said hydroxyl group.

15. A process according to claim 1, in which (A) is of the general formula

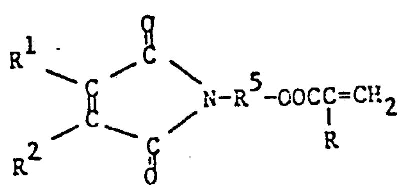 (XXIV)

wherein R, $R^1$, and $R^2$ are as defined in claim 1, and $R^5$ is as defined in claim 7.

16. A process according to claim 1, in which (A) is of the general formula

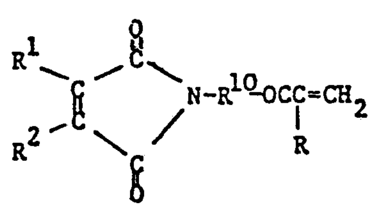 (XXV)

wherein R, $R^1$, and $R^2$ are as defined in claim 1 and $R^{10}$ is an imino group, an oxyalkylene group of 1 to 10 carbon atoms, a 2-hydroxyoxypropylene group, a poly (oxyalkylene) group of 4 to 12 carbon atoms, a cyclooxyalkene group of 5 to 7 carbon atoms, or an alkylenecarbonamido group of 2 to 10 carbon atoms.

17. A process according to any one of the preceding claims, in which each of $R^1$ and $R^2$ is a methyl group.

18. A process according to claim 17, in which (A) is N-(2-(acryloyloxy)ethyl-2,3-dimethylmaleimide, N-(3-(acryloyloxy)-2-hydroxypropyl)-2,3-dimethylmaleimide, N-(3-(acryloyloxy)propyl)-2,3-dimethylmaleimide, N-(2-(methacryloyloxy)ethyl)-2,3-dimethylmaleimide, N-(3-(methacryloyloxy)-2-hydroxypropyl)-2,3-dimethylmaleimide, N-(3-(methacryloyloxy)propyl)-2,3-dimethylmaleimide,• or N-(2(-methacryloyloxy)ethoxy)ethyl)-2,3-dimethylmaleimide.

19. A process according to claim 1, in which the composition contains as (A) a compound of formula XVII as defined in claim 11, wherein $R^8$ is a hydrogen atom, and the solvent employed for development is an aqueous solution of a base.

20. A process according to any one of claims 1 to 18, in which the composition further comprises a photopolymerisable compound (B) having in the molecule at least one group of formula I but none of formula II and also at least one free sulfonic, phosphonic, or carboxylic acid group and the solvent employed for development is an aqueous solution of a base.

21. A process according to any one of claims 1 to 18, in which the composition contains a photopolymerisable compound (B) having in the molecule at least one group of formula I but none of formula II and also at least one primary, secondary, or tertiary amino group, and the solvent employed is an aqueous solution of an acid.

**Revendications**

1. Procédé pour créer une image, procédé caractérisé en ce que

(1) on expose à un rayonnement actinique une couche appliquée sur un support, d'une composition liquide contenant un composé (A) qui renferme, dans une même molécule, à la fois au moins un radical répondant à la formule I

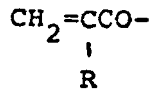

(I)

dans laquelle R représente un atome d'hydrogène ou un radical méthyle, et au moins un radical répondant à la formule II

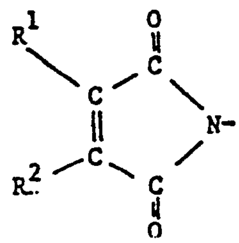

(II)

dans laquelle $R^1$ et $R^2$ représentent chacun, indépendemment l'un de l'autre, un radical alkyle contenant de 1 à 4 atomes de carbone ou forment ensemble un radical triméthylène ou tétraméthylène éventuellement porteur d'un radical méthyle, cette exposition étant telle que la couche se solidifie par photopolymérisation de (A) par l'intermédiaire du ou des radicaux de formule I et devienne pratiquement non collante mais tout en conservant largement son aptitude à se photoréticuler, puis

(2) on expose la couche ainsi solidifiée, à travers un cliché portant une image et présentant des endroits pratiquement opaques et des endroits pratiquement transparents, à une quantité de rayonnement actinique beaucoup plus grande de telle façon que le ou les endroits ainsi surexposés de la couche photopolymérisée subissent une photoréticulation par l'intermédiaire du ou des radicaux de formule II, et

(3) on développe l'image en dissolvant dans un solvant les endroits non photoréticulés de la couche.

2. Procédé selon la revendication 1 caractérisé en ce que le composé (A) contient, par molécule moyenne, au plus quatre radicaux de formule I.

3. Procédé selon l'une des revendications 1 et 2, caractérisé en ce que le composé (A) contient, par molécule moyenne, au moins quatre radicaux de formule II.

4. Procédé selon l'une quelconque des revendications précédentes, caractérisé en ce que le ou les radicaux de formule I est ou sont fixés directement sur un ou des atomes de carbone, d'oxygène ou d'azote.

5. Procédé selon l'une quelconque des revendications précédentes, caractérisé en ce que le ou les radicaux de formule II est ou sont fixés directement sur un ou des atomes de carbone, d'oxygène ou d'azote.

6. Procédé selon l'une quelconque des revendications 1 à 3, caractérisé en ce que le composé (A) répond à la formule IV

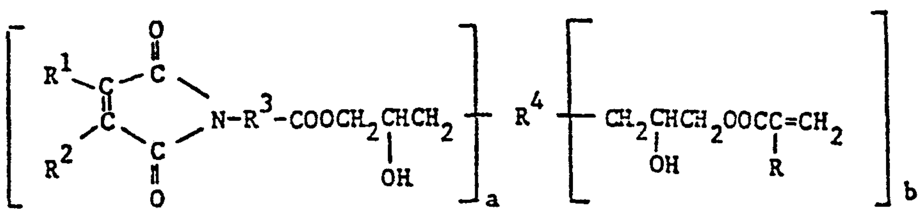

(IV)

dans laquelle a et b représentent chacun, indépendamment l'un de l'autre, un nombre entier au moins égal à 1, R, $R^1$ et $R^2$ ont les significations données à la revendication 1, $R^3$ représente le radical bivalent qui subsite lorsqu'on a amputé d'un radical amino primaire et d'un radical carboxy un composé contenant au moins un tel radical amino et au moins un radical carboxy, et $R^4$ représente le radical qui subsiste lorsqu'on a amputé de (a + b) radicaux glycidyles directement reliés à un ou à des atomes d'oxygène, d'azote ou de soufre un composé contenant au moins (a + b) radicaux glycidyles de ce genre.

7. Procédé selon l'une quelconque des revendications 1 à 3, caractérisé en ce que le composé (A) répond à la formule VIII

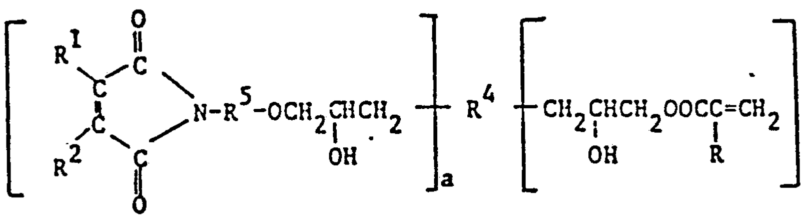

(VIII)

dans laquelle a et b ont chacun la signification qui lui a été donnée à la revendication 6, R, $R^1$ et $R^2$ ont les significations données à la revendication 1, $R^4$ a la signification donnée à la revendication 6 et $R^5$ représente le radical que laisse un composé contenant au moins un radical amino primaire et au moins un radical hydroxy phénolique après qu'on en a enlevé un tel radical amino et un tel radical hydroxy.

8. Procédé selon l'une quelconque des revendications 1 à 3, caractérisé en ce que le composé (A) répond à la formule XI

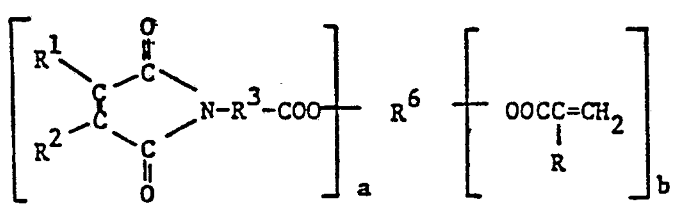

(XI)

dans laquelle a et b ont chacun la signification qui lui a été donnée à la revendication 6, R, $R^1$ et $R^2$ ont les significations données à la revendication 1, $R^3$ a la signification donnée à la revendication 6 et $R^6$ représente le radical qu'on obtient en enlevant (a + b) radicaux hydroxy alcooliques d'un alcool contenant au moins (a + b) radicaux hydroxy de ce genre.

9. Procédé selon la revendication 1, caractérisé en ce que le composé (A) répond à la formule générale XIV

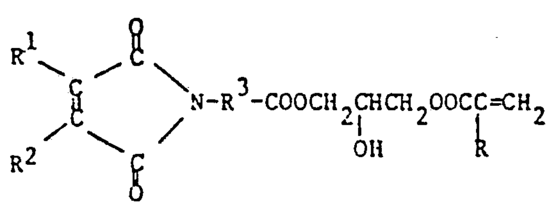

(XIV)

dans laquelle R, $R^1$ et $R^2$ ont les significations données à la revendication 1 et $R^3$ a la signification donnée à la revendication 6.

10. Procédé selon la revendication 1 caractérisé en ce que le composé (A) répond à la formule générale XV

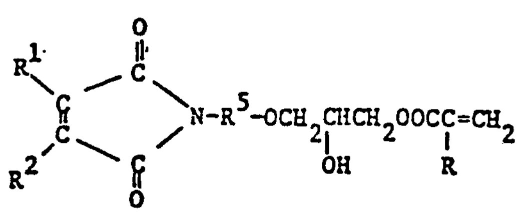

(XV)

dans laquelle R, $R^1$ et $R^2$ ont les significations données à la revendication 1 et $R^5$ a la signification donnée à la revendication 7.

11. Procédé selon la revendication 1 caractérisé en ce que le composé (A) répond à la formule générale XVII

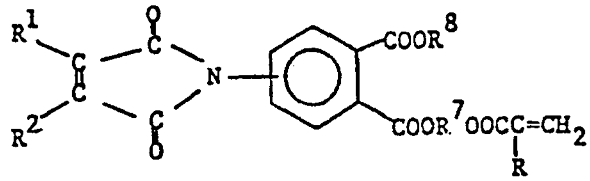

(XVII)

dans laquelle R, $R^1$ et $R^2$ ont les significations données à la revendication 1, $R^7$ représente un radical alkylène contenant 2 ou 3 atomes de carbone et $R^8$ représente un atome d'hydrogène ou un radical répondant à la formule XVIII

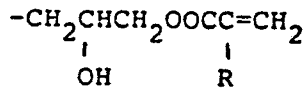

(XVIII)

ou à la formule XIX

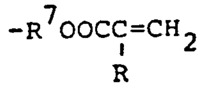

(XIX)

12. Procédé selon la revendication 1 caractérisé en ce que le composé (A) répond à la formule générale XX

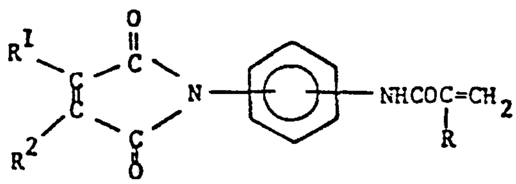

(XX)

dans laquelle R, $R^1$ et $R^2$ ont les significations données à la revendication 1.

13. Procédé selon la revendication 1 caractérisé en ce que le composé (A) répond à la formule générale XXI

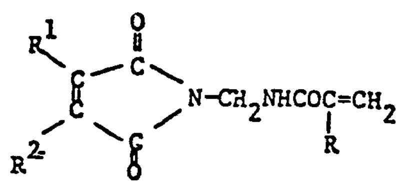

(XXI)

dans laquelle R, $R^1$ et $R^2$ ont les significations données à la revendication 1.

14. Procédé selon la revendication 1 caractérisé en ce que le composé (A) répond à la formule générale XXII

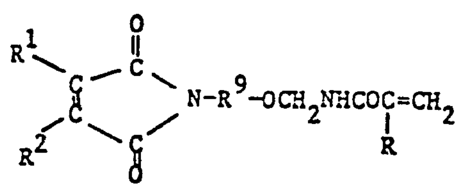

(XXII)

dans laquelle R, $R^1$ et $R^2$ ont les significations données à la revendication 1 et $R^9$ représente le radical bivalent qui reste après qu'on a amputé d'un radical amino primaire et d'un radical hydroxy alcoolique un composé contenant au moins un tel radical amino et au moins un tel radical hydroxy.

15. Procédé selon la revendication 1 caractérisé en ce que le composé (A) répond à la formule générale XXIV

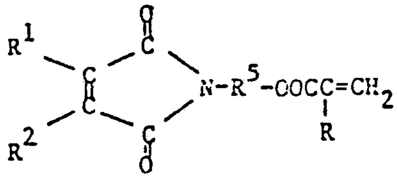

(XXIV)

dans laquelle R, $R^1$ et $R^2$ ont les significations données à la revendication 1 et $R^5$ a la signification donnée à la revendication 7.

16. Procédé selon la revendication 1 caractérisé en ce que le composé (A) répond à la formule générale XXV

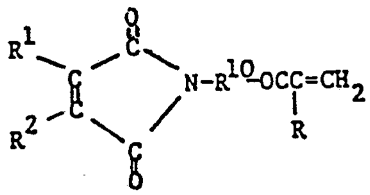

(XXV)

dans laquelle R, $R^1$ et $R^2$ ont les significations données à la revendication 1 et $R^{10}$ représente un radical imino, un radical alkylène-oxy contenant de 1 à 10 atomes de carbone, un radical hydroxy-2 propylène-oxy, un radical poly-(oxy-alkylène) contenant de 4 à 12 atomes de carbone, un radical cycloalkylène-oxy contenant de 5 à 7 atomes de carbone ou un radical alkylène-carbonylamino contenant de 2 à 10 atomes de carbone.

17. Procédé selon l'une quelconque des revendications précédentes, caractérisé en ce que $R^1$ et $R^2$ représentent chacun un radical méthyle.

18. Procédé selon la revendication 17 caractérisé en ce que le composé (A) est le N-(acryloyloxy-2 éthyl) diméthyl-2,3 maléimide, le N-(acryloyloxy-3 hydroxy-2 propyl) diméthyl-2,3 maléimide, le N-(acryloyloxy-3 propyl) diméthyl-2,3 maléimide, le N-(méthacryloyloxy-2 éthyl) diméthyl-2,3 maléimide, le N-(méthacryloyloxy-3 hydroxy-2 propyl) diméthyl-2,3 maléimide, le N-(méthacryloyloxy-3 propyl) diméthyl-2,3 maléimide, ou le N-[(méthacryloyloxy-2 éthoxy)-2 éthyl] diméthyl-2,3 maléimide.

19. Procédé selon la revendication 1 caractérisé en ce que la composition contient, comme composé (A), un composé de formule XVII tel que défini à la revendication 11 dans lequel $R^8$ représente un atome d'hydrogène, et le solvant utilisé pour le développement est une solution aqueuse d'une base.

20. Procédé selon l'une quelconque des revendications 1 à 18, caractérisé en ce que la composition renferme en outre un composé photopolymérisable (B) dont la molécule contient au moins un radical de formule I mais est dépourvue de radical de formule II et contient au moins un radical d'acide sulfonique, phosphonique ou carboxylique libre, et le solvant utilisé pour le développement est une solution aqueuse d'une base.

21. Procédé selon l'une quelconque des revendications 1 à 18, caractérisé en ce que la composition renferme un composé photopolymérisable (B) dont la molécule contient au moins un radical de formule I mais est dépourvu de radical de formule II et contient au moins un radical amino primaire, secondaire ou tertiaire, et le solvant utilisé est une solution aqueuse d'un acide.